# EUROPÄISCHE PATENTSCHRIFT

(11) **EP 4 449 485 B1**
(45) Veröffentlichungstag und Bekanntmachung des Hinweises auf die Patenterteilung: **28.01.2026**
(21) Anmeldenummer: 21840558.7
(22) Anmeldetag: 17.12.2021
(51) Int. Cl.: H01L 21/68, H01L 23/544

(54) **VERFAHREN UND VORRICHTUNG ZUM AUSRICHTEN EINES SUBSTRATES**
METHOD AND DEVICE FOR ALIGNING A SUBSTRATE
PROCÉDÉ ET DISPOSITIF D'ALIGNEMENT D'UN SUBSTRAT

(43) Veröffentlichungstag der Anmeldung: 23.10.2024
(73) Patentinhaber: EV Group E. Thallner GmbH, 4782 St. Florian am Inn (AT)
(72) Erfinder: WAGENLEITNER, Thomas, 4782 St. Florian am Inn (AT); ROHRINGER, Harald, 4782 St. Florian am Inn (AT)
(74) Vertreter: Schneider, Sascha
(86) Internationale Anmeldenummer: PCT/EP2021/086374
(87) Internationale Veröffentlichungsnummer: WO 2023/110113

(56) Entgegenhaltungen:
- EP-A1- 3 734 650
- EP-B1- 3 011 589
- CN-A- 111 354 714
- CN-A- 111 933 618
- US-A- 5 843 831

## Beschreibung

Die vorliegende Erfindung betrifft ein Verfahren und eine Vorrichtung zum Ausrichten eines Substrates.

In der Halbleiterindustrie werden Ausrichtungsanlagen (engl.: aligner) verwendet, um Substrate, insbesondere Wafer, zueinander auszurichten oder zu anderen Bauteilen auszurichten. Substrate können jede beliebige Form besitzen und sind bevorzugt kreisrund. Der Durchmesser der Substrate ist insbesondere industriell genormt. Für Wafer sind die industrieüblichen Durchmesser, 1 Zoll, 2 Zoll, 3 Zoll, 4 Zoll, 5 Zoll, 6 Zoll, 8 Zoll, 12 Zoll und 18 Zoll. In speziellen Ausführungsformen der Ausrichtungsanlagen können insbesondere auch eckige Substrate oder Paneele zueinander mit höchster Genauigkeit ausgerichtet und gebondet werden.

Das Fügen von insbesondere ausgerichteten Halbleitersubstrate wird als Bonden bezeichnet.

Bei dem sogenannten Bonden werden die zu verbondenden Substrate zueinander ausgerichtet und in einem weiteren Prozessschritt miteinander verbunden. Dabei ist eine besonders genaue Ausrichtung der Substrate zueinander notwendig.

Ausrichtungsvorgänge, bei denen sich die Ausrichtungsmarkierungen an den zu verbondenden Substratoberflächen befinden werden als face-to-face Ausrichtungen bezeichnet.

Soweit zumindest eines der Substrate für die elektromagnetische Strahlung, welche zur Vermessung der Substrate verwendet wird, nicht transparent ist, um eine Erfassung und/oder Bestimmung der Position und Lage der Ausrichtungsmarkierungen von den zu verbondenden Substratoberflächen abgewandten, äußeren Substratoberflächen her zu ermöglichen, werden Ausrichtungsmarkierungen im Stand der Technik mit Bilderfassungsmitteln zwischen den Substraten erfasst bevor die Substrate aneinander angenähert werden.

Dies hatte verschiedene Nachteile. Insbesondere können Partikel von der Kamera auf die Substratoberflächen eingebracht werden. Weiterhin muss ein großer Abstand zwischen den Substraten gefahren werden, um die Kamera zur Erfassung zwischen beiden Substraten zu platzieren. Dabei entstehen durch das aufwendigere Ausrichten und die entsprechend größeren Verfahrwege auch größere Ausrichtungsfehler.

Insbesondere bei der gegenseitigen Annäherung der zu verbondenden Substrate und dem Einstellen eines bestimmten Abstandes zwischen den Bondflächen, ist eine optimale Ausrichtung essenziell, um ein möglichst gutes Bondergebnis zu erhalten.

Ein weiteres Problem mit dem Stand der Technik besteht darin, dass steigenden Ausrichtungsgenauigkeitsanforderungen nicht mehr mit einfachen Mitteln erreicht werden können. In Bezug auf Verfahren bei denen Substrate relativ zu Referenzpunkten vermessen und beispielsweise nach einer Annäherung zum Kontaktieren blind ausgerichtet werden, werden die neuen Ausrichtungsgenauigkeitsanforderungen nicht erreicht.

Beispielsweise basiert die Druckschrift US6214692B1 auf dem Vergleich und der Positionskorrektur zweier Bilder von Ausrichtungsmarkierungen. Die Lage von Ausrichtungsmarkierungen auf den beiden, face-to-face angeordneten Substraten, wird einzeln mittels eines Kamerasystems erfasst. Aus einer berechneten Relativlage und Relativposition der Ausrichtungsmarkierungen wird ein Positioniertisch (Substrathalter und Stage) so angesteuert, dass die Fehlposition korrigiert wird. Die weitere Druckschrift US10692747B2 basiert auf dem Vergleich und der Positionskorrektur insgesamt dreier Bilder von ebenen Ausrichtungsmarkierungen. Die Lage von Ausrichtungsmarkierungen auf den beiden, face-to-face angeordneten Substraten, wird einzeln mittels eines Kamerasystems erfasst. Von einer dritten Erfassungseinheit wird eine dritte Ausrichtungsmarkierung erfasst, mit welcher eine Korrelation einer Ausrichtungsmarke des Substrats zur Rückseite des Substrathalters oder zur Rückseite des Substrates hergestellt wird, sodass eine genauere Ausrichtung zweier Substrate ermöglicht wird.

Weitere Vorrichtungen und Verfahren sind aus den Druckschriften EP3734650A1 sowie der CN111354714A bekannt.

Insofern ist eine Sichtkontrolle bei einer face-to-face Ausrichtung von zwei Substraten nicht möglich beziehungsweise nur möglich, wenn zumindest eins der Substrate zumindest teilweise transparent ist. Ein genaues Ausrichten der Oberflächen bei einer face-to-face Ausrichtung ist daher nur aufwendig und eingeschränkt möglich.

Es hat sich insbesondere als nachteilig herausgestellt, dass bei einer Erfassung von Ausrichtungsmarkierungen eine Refokussierung beziehungsweise Umfokussierung notwendig ist. Dabei ist eine Refokussierung bei Nachstellbewegungen, insbesondere der Optiken zur Erfassung der Ausrichtungsmarken, prinzipbedingt notwendig. Nachstellbewegungen verlaufen neben der benötigten Bewegung mit dazu überlagerten, parasitären Bewegungen, welche Abweichungen von der idealen Bewegung der jeweiligen Optik verursachen. Daher kommt es bei einer Bewegung zu einer Verschiebungen des Fokuspunktes. Der Fokuspunkt wird beispielsweise in der zur Optik beziehungsweise einer optischen Achse der Optik normal aufgespannten Ebene x-y verschoben. Die Verschiebung des Fokuspunktes setzt die Genauigkeit der Vermessung der Ausrichtungsmarkierungen herab, welche die Ausrichtungsgenauigkeit reduziert.

Es ist daher Aufgabe der vorliegenden Erfindung ein Verfahren und eine Vorrichtung zum Ausrichten eines Substrates aufzuzeigen, welche die im Stand der Technik aufgeführten Nachteile zumindest zum Teil beseitigen, insbesondere vollständig beseitigen. Es ist insbesondere Aufgabe der Erfindung ein verbessertes Verfahren und eine verbesserte Vorrichtung zum Ausrichten eines Substrates aufzuzeigen. Es ist insbesondere Aufgabe der vorliegenden Erfindung ein Verfahren und eine Vorrichtung zum Ausrichten eines Substrates aufzuzeigen, welche keine Refokussierung einer Erfassungseinheit beim Ausrichten benötigen. Es ist weiterhin Aufgabe der vorliegenden Erfindung ein Verfahren und eine Vorrichtung zum Ausrichten eines Substrates aufzuzeigen, welches besonders zuverlässig, genau und frei von Kontamination durchführbar ist beziehungsweise welche besonders zuverlässig, genau und frei von Kontamination ausrichtet.

Die vorliegende Aufgabe wird mit den Merkmalen der nebengeordneten Ansprüche gelöst. Vorteilhafte Weiterbildungen der Erfindung sind in den Unteransprüchen angegeben. In den Rahmen der Erfindung fallen auch sämtliche Kombinationen aus zumindest zwei in der Beschreibung, in den Ansprüchen und/oder den Zeichnungen angegebenen Merkmalen. Bei angegebenen Wertebereichen sollen auch innerhalb der genannten Grenzen liegende Werte als Grenzwerte offenbart gelten und in beliebiger Kombination beanspruchbar sein.

Demnach betrifft die Erfindung ein Verfahren zum Ausrichten eines Substrates mit zumindest den folgenden Schritten:
i) Bereitstellung eines Substrathalters mit einer zur Aufnahme des Substrates ausgebildeten Substrathalteroberfläche und eines zu dem Substrathalter ortsfest angeordneten Ausrichtungsmarkierungsfeldes,
ii) Ausrichten des Substrates,
   dadurch gekennzeichnet, dass das Substrat anhand von übereinander angeordneten Ausrichtungsmarken des Ausrichtungsmarkierungsfeldes ausgerichtet wird, wobei das Ausrichten des Substrates in Schritt ii) die folgenden Schritte aufweist, insbesondere mit dem folgenden Ablauf:
      a) Erfassung einer ersten Ausrichtungsmarke einer ersten Ebene des Ausrichtungsmarkierungsfeldes durch eine Erfassungseinheit,
      b) Fixierung einer Fokusposition der Erfassungseinheit nach der Erfassung in Schritt a),
      c) Bewegung des Substrathalters senkrecht zu der ersten Ebene des Ausrichtungsmarkierungsfeldes,
      d) Erfassung einer zweiten Ausrichtungsmarke einer zweiten Ebene des Ausrichtungsmarkierungsfeldes durch die Erfassungseinheit,
   wobei die erste Ebene und die zweite Ebene zueinander parallel angeordnet sind, und wobei die erste Ebene und die zweite Ebene einen Abstand zueinander aufweisen.

Das Substrat beziehungsweise einen Substratstapel wird dabei anhand der übereinander angeordneten Ausrichtungsmarken ausgerichtet. Das Ausrichtungsmarkierungsfeld ist dabei ortsfest zu dem Substrathalter beziehungsweise zu der Substrathalteroberfläche angeordnet. Dabei ist insbesondere die genaue Lage des Ausrichtungsmarkierungsfeldes und die jeweilige Lage der Ausrichtungsmarken in dem Ausrichtungsmarkierungsfeld relativ zu dem Substrathalter bekannt. Die Ausrichtungsmarken beziehungsweise zumindest zwei Ausrichtungsmarken des Ausrichtungsmarkierungsfeldes sind dabei übereinander angeordnet.

Die Anordnung von zumindest zwei Ausrichtungsmarken des Ausrichtungsmarkenfeldes übereinander bedeutet, dass diese in unterschiedlichen Ebenen angeordnet sind. Das Ausrichtungsmarkierungsfeld weist somit eine bestimmte Höhe (z-Richtung) relativ zu der Substrathalteroberfläche auf. Die mindestens zwei Ausrichtungsmarken sind somit in voneinander unterschiedlichen z-Ebenen angeordnet.

Dabei verdecken die Ausrichtungsmarken sich in z-Richtung bevorzugt nicht, sodass die Betrachtung der mindestens zwei Ausrichtungsmarken des Ausrichtungsmarkenfeldes aus einer Betrachtungsrichtung hindernisfrei erfolgen kann. Mit anderen Worten sind die Ausrichtungsmarken eines Ausrichtungsmarkenfeldes bevorzugt zueinander versetzt, in zueinander parallelen Ebenen übereinander angeordnet, sodass eine beliebige Ausrichtungsmarke in einer beliebigen Ebene des Ausrichtungsmarkierungsfeldes wahrnehmbar ist.

Weiterhin ist denkbar, dass die die mindestens zwei übereinander angeordneten Ausrichtungsmarken des Ausrichtungsmarkierungsfeldes in z-Richtung teilweise oder vollständig überlappend angeordnet sind. In anderen Worten können, die mindestens zwei übereinander angeordneten Ausrichtungsmarken, in z-Richtung zumindest teilweise zueinander fluchtend angeordnet sein. In diesem Fall sind die unterschiedlichen z-Ebenen beziehungsweise Schichten des Ausrichtungsmarkierungsfelds insbesondere für unterschiedliche Wellenlängen transparent, sodass eine weitere beliebige Ausrichtungsmarke in einer beliebigen anderen Ebene des Ausrichtungsmarkierungsfeldes erfassbar ist. Dabei wird beziehungsweise werden die in Betrachtungsrichtung vorgelagerten Ebenen/Schichten und/oder die vorgelagerten Ausrichtungsmarken zur Betrachtung durchdrungen, sodass die zumindest teilweise fluchtende Ausrichtungsmarke einer nachfolgenden Ebene erfassbar ist.

Bei einer Erfassung einer Ausrichtungsmarke und einer anschließenden Erfassung einer darüber angeordneten Ausrichtungsmarke, kann somit die jeweilige bekannte Lage der Ausrichtungsmarken verglichen werden. Da die Beschaffenheit und die Strukturen sowie die Lagen des Ausrichtungsmarkierungsfeldes vorzugsweise bekannt sind, kann somit der Abstand zwischen den Ausrichtungsmarken erfasst werden. Anhand dieses Abstands kann beispielsweise durch eine Relativbewegung des Substrathalters eine Ausrichtung anhand der übereinander angeordneten Ausrichtungsmarken vorgenommen werden, ohne dass eine Refokussierung von Erfassungsmitteln notwendig ist. Auf diese Weise kann ein Substrat besonders genau in zumindest eine Richtung ausgerichtet werden, da der bekannte Abstand zwischen den übereinander angeordneten Ausrichtungsmarken erfasst werden und somit eingestellt werden kann.

Weiterhin kann mit der genauen Ausrichtung in zumindest eine Richtung vorteilhaft ein Bondabstand (Bondgap) sehr einfach und exakt angefahren werden. Dabei kann vorteilhaft durch eine direkte Sichtkontrolle der Substrathalter in Abhängigkeit von dem Ausrichtungsmarkierungsfeld ausgerichtet werden. Zudem wird zum Ausrichten lediglich ein Erfassungsmittel benötigt, wodurch die Fehleranfälligkeit reduziert wird. Insbesondere bei dem Bonden von nicht transparenten Substraten in einem Face-to-Face Verfahren kann daher vorteilhaft eine genaue Position des Substrathalters und damit des Substrat eingestellt werden. Durch die übereinander angeordneten Ausrichtungsmarken und die somit bereitgestellte Höheninformation kann somit vorteilhaft eine Ausrichtung ohne eine Umfokussierung der Erfassungsmittel erfolgen. Somit kann das auszurichtenden Substrat um einen bestimmten Abstand besonders genau und unter Sichtkontrolle bewegt werden.

In dem Verfahren zum Ausrichten eines Substrates ist vorgesehen, dass das Ausrichten des Substrates in Schritt ii) zumindest die folgenden Schritte aufweist, insbesondere mit dem folgenden Ablauf:
a) Erfassung einer ersten Ausrichtungsmarke einer ersten Ebene des Ausrichtungsmarkierungsfeldes durch eine Erfassungseinheit,
b) Fixierung einer Fokusposition der Erfassungseinheit nach der Erfassung in Schritt a),
c) Bewegung des Substrathalters senkrecht zu der ersten Ebene des Ausrichtungsmarkierungsfeldes,
d) Erfassung einer zweiten Ausrichtungsmarke einer zweiten Ebene des Ausrichtungsmarkierungsfeldes durch die Erfassungseinheit,
wobei die erste Ebene und die zweite Ebene zueinander parallel angeordnet sind, und wobei die erste Ebene und die zweite Ebene einen Abstand zueinander aufweisen.

In dem Ausrichtungsmarkierungsfeld sind vorzugsweise mehrere Ausrichtungsmarken nebeneinander in der jeweiligen Ebene angeordnet. Es wird somit mindestens eine erste Ausrichtungsmarke beziehungsweise mindestens eine zweite Ausrichtungsmarke der entsprechenden Ebene erfasst. Weiterhin ist das Ausrichtungsmarkierungsfeld zwischen den Ebenen vorzugsweise transparent für die Erfassungseinheit ausgebildet, so dass die übereinander angeordneten Ausrichtungsmarken erfassbar sind. Denkbar ist auch, dass die Ausrichtungsmarken der ersten Ebene versetzt zu den Ausrichtungsmarken der zweiten Ebene angeordnet sind und das Ausrichtungsmarkierungsfeld unterschiedliche Abstufungen aufweist. Zudem kann die Erfassungseinheit neben der jeweiligen ersten Ausrichtungsmarke auch weitere Ausrichtungsmarken der ersten Ebene erfassen, solange diese in dem Fokusbereich angeordnet sind. Selbiges gilt dann auch für die zweite Ebene. Dabei ist die Erfassungseinheit so ausgebildet, dass mehrere Ausrichtungsmarken, insbesondere nebeneinander angeordnete Ausrichtungsmarken der jeweiligen Ebene erfassbar sind.

Bei einer Erfassung der ersten Ausrichtungsmarke auf der ersten Ebene des Ausrichtungsmarkierungsfeldes wird durch die Erfassungseinheit die jeweilige Ausrichtungsmarke identifiziert. Die Erfassungseinheit weist vorzugsweise Fokussierungsmittel, vorzugsweise ein Objektiv, auf, welche die erste Ausrichtungsmarke bei der Erfassung fokussiert beziehungsweise scharf stellt. Dabei nimmt die Erfassungseinheit beziehungsweise das Objektiv eine Fokusposition ein, in welcher die Erfassungseinheit einen bestimmten Fokusbereich erfassen kann. Der Fokusbereich einer bestimmten Fokusposition der Erfassungseinheit beziehungsweise des Objektives ist somit fokussiert und innerhalb des Fokusbereiches angeordnete Ausrichtungsmarken erfassbar. Bei einer Erfassung sind vorzugsweise nur Ausrichtungsmarken der jeweiligen Ebene erfassbar beziehungsweise identifizierbar, da ein Fokusbereich bei der Erfassungseinheit jeweils nur genau eine Ebene beinhaltet. Der Abstand zwischen der ersten Ebene und der zweiten Ebene ist somit vorzugsweise größer als die Tiefe des Fokusbereiches.

Im Anschluss an das Erfassen der ersten Ausrichtungsmarke der ersten Ebene wird die Fokusposition der Erfassungseinheit fixiert. Somit wird insbesondere der Fokusbereich festgelegt, so dass die Erfassungseinheit im Folgenden vorzugsweise nur noch Ausrichtungsmarken innerhalb des festgelegten Fokusbereiches erfassen kann. Danach wird durch ein Bewegen des Substrathalters senkrecht zu der ersten Ebene des Ausrichtungsmarkierungsfeldes das Substrat auf der Substrathalteroberfläche des Substrathalters mitbewegt und somit ausgerichtet. Der Substrathalter wird zumindest so weit bewegt, bis die Erfassungseinheit die zweite Ausrichtungsmarke in der zweiten Ebene des Ausrichtungsmarkierungsfeldes erfassen kann. Insoweit wird durch die Bewegung des Substrathalters vorteilhaft das Substrat um den Abstand, welcher zur Scharfstellung benötigt wird, bewegt. Beispielsweise kann auf diese Weise ein Bondabstand zwischen dem Substrat und einem anderen zu verbondenden Substrat eingestellt werden. Ausrichtungsfehler aufgrund einer Refokussierung der Erfassungseinheit können somit vorteilhaft verhindert werden.

In einer bevorzugten Ausführungsform des Verfahrens zum Ausrichten eines Substrates ist vorgesehen, dass in Schritt a) zusätzliche Ausrichtungsmarken an dem Substrathalter oder auf dem Substrat von mindestens einer zusätzlichen Erfassungseinheit erfasst werden.

Die zusätzlichen Ausrichtungsmarken beziehungsweise die zusätzlichen Ausrichtungsmarkierungen können in dabei vorteilhaft zu einer Position der ersten Ausrichtungsmarke korreliert beziehungsweise in räumlichen Bezug gesetzt werden. Bei den zusätzlichen Ausrichtungsmarkierungen handelt es sich insbesondere um ein flächiges Ausrichtungsmarkierungsfeld ohne übereinander angeordnete Ausrichtungsmarken. In anderen Worten sind diese zusätzlichen Ausrichtungsmarkierungen nicht in Ebenen übereinander angeordnet.

Mit den zusätzlichen Ausrichtungsmarkierungen kann vorteilhaft auch das Ausrichten des Substrathalters relativ zu den Ausrichtungsmarken des Ausrichtungsmarkierungsfeldes erfolgen. Weiterhin kann ein Ausrichten des Substrathalters beziehungsweise des auf dem Substrathalter angeordneten Substrates durch die Erfassungseinheit auch relativ zu den zusätzlichen Ausrichtungsmarkierungen erfolgen. Durch die mindestens eine zusätzliche Erfassungseinheit kann insbesondere die Position eines mit dem Substrat zu verbondenden zusätzlichen Substrates relativ zu dem Ausrichtungsmarkierungsfeld bestimmt werden. Ein Ausrichten kann durch die zusätzliche Ausrichtungsmarken und die zusätzliche Erfassungseinheit noch genauer erfolgen.

In einer bevorzugten Ausführungsform des Verfahrens zum Ausrichten eines Substrates ist vorgesehen, dass während der Bewegung des Substrathalters in Schritt iv) die Erfassungseinheit in der Fokusposition kontinuierlich das Ausrichtungsmarkierungsfeld vermisst.

Sind zwischen der ersten Ebene und der zweiten Ebene weitere Ausrichtungsmarken in weiteren Ebenen angeordnet, können diese bei der Bewegung des Substrathalters von der Erfassungseinheit vermessen werden, so dass das Bewegen des Substrathalters besonders genau und kontrolliert durchführbar ist. Weiterhin kann durch mehrere erfasste Ausrichtungsmarken, deren Lage im Ausrichtungsmarkierungsfeld bekannt ist, die Ausrichtung noch genauer erfolgen.

In einer bevorzugten Ausführungsform des Verfahrens zum Ausrichten eines Substrates ist vorgesehen, dass nach der Fixierung der Fokusposition in Schritt b) die Erfassungseinheit ortsfest gehalten wird.

Dabei wird die Erfassungseinheit nicht nur in einem bestimmten Abstand zum Ausrichtungsmarkierungsfeld fixiert, sondern auch in einer horizontalen Lage. Die ortsfeste Fixierung relativ zu dem Ausrichtungsmarkierungsfeld bewirkt somit insbesondere auch eine ortsfeste Fixierung in Bezug auf den Substrathalter und folglich zu dem auf dem Substrathalter angeordneten Substrat. Auf diese Weise wird vorteilhaft sichergestellt, dass neben der Fixierung der Fokusposition der Erfassungseinheit beziehungsweise des Objektivs auch die Position der Erfassungseinheit festgelegt wird. Auf diese Weise ist das Substrat noch genauer ausrichtbar und ein Fehler beim Ausrichten aufgrund von einer ungenauen Bewegung der Erfassungseinheit wird vermieden.

In einer bevorzugten Ausführungsform des Verfahrens zum Ausrichten eines Substrates ist vorgesehen, dass bei dem Erfassen der ersten Ausrichtungsmarke in Schritt a) und/oder bei dem Erfassen der zweiten Ausrichtungsmarke in Schritt d) von der Erfassungseinheit zusätzlich eine Information über die Lage der jeweiligen Ausrichtungsmarke innerhalb des Ausrichtungsmarkierungsfeldes bereitgestellt wird.

Die Ausrichtungsmarken weisen bevorzugt eine Information bezüglich ihrer jeweiligen Lage innerhalb des Ausrichtungsmarkierungsfeldes auf. Dabei ist neben der Lage entlang des Ausrichtungsmarkierungsfeldes (x-y-Lage) auch die jeweilige Höhe beziehungsweise der Abstand der Ebenen zueinander bekannt. Wird somit die erste Ausrichtungsmarke erfasst, kann vorteilhaft festgestellt werden, in welcher Ebene diese angeordnet ist. Insbesondere wenn ein Ausrichtungsmarkierungsfeld mehr als zwei Ebenen mit unterschiedlichen Abständen zueinander aufweist, kann somit die Ausrichtung einfacher gesteuert oder geregelt werden, da die jeweilige Höheninformation bezüglich der Ausrichtungsmarke erfasst wird. Beispielsweise kann bei einer kontinuierlichen Erfassung bei dem Bewegen oder bei der Erfassung der ersten Ausrichtungsmarke vorteilhaft festgestellt werden, welche Ebene beziehungsweise Stufe im Fokusbereich erfasst wird. Wird zudem eine Position zwischen zwei Ebenen beziehungsweise Stufen erfasst, kann vorteilhaft eine darüber oder darunter angeordnete Ebene beziehungsweise Stufe angefahren werden. Weiterhin kann vorteilhaft die Lage in x-y-Position erfasst und kontrolliert werden.

Die vorgenannten Vorteile und Merkmale in Bezug auf das das Verfahren zum Ausrichten sollen auch im Zusammenhang mit der folgenden Vorrichtung offenbart sein.

Weiterhin betrifft die Erfindung eine Vorrichtung zum Ausrichten eines Substrates, zumindest aufweisend:
A) einen Substrathalter mit einer zur Aufnahme des Substrates ausgebildeten Substrathalteroberfläche, und
B) ein zu dem Substrathalter und/oder zu dem Substrat ortsfest angeordnetes Ausrichtungsmarkierungsfeld mit Ausrichtungsmarken,

dadurch gekennzeichnet, dass das Substrat anhand von übereinander angeordneten Ausrichtungsmarken ausrichtbar ist,
die Vorrichtung ferner aufweisend:
   C) eine Erfassungseinheit zur Erfassung der Ausrichtungsmarken des Ausrichtungsmarkierungsfeldes und
   D) eine Bewegungseinrichtung zum Bewegen des Substrathalters,
wobei die Ausrichtungsmarken des Ausrichtungsmarkierungsfeldes in einer ersten Ebene und einer zweiten Ebene angeordnet sind, und wobei die erste Ebene und die zweiten Ebene parallel zueinander angeordnet sind, und wobei die erste Ebene und die zweite Ebene einen Abstand zueinander aufweisen, und wobei eine erste Ausrichtungsmarke der Ausrichtungsmarken der ersten Ebene in einer Fokusposition der Erfassungseinheit erfassbar ist, und wobei die Fokusposition der Erfassungseinheit fixierbar ist, und wobei in der Fokusposition durch die Erfassungseinheit eine zweite Ausrichtungsmarke der Ausrichtungsmarken der zweiten Ebene erfassbar ist, und wobei der Substrathalter senkrecht zu der ersten Ebene durch die Bewegungseinrichtung bewegbar ist.

Die übereinander angeordneten Ausrichtungsmarken des Ausrichtungsmarkierungsfeldes weisen in eine Richtung des Ausrichtungsmarkierungsfeldes einen bekannten Abstand zueinander auf. Auf diese Weise kann vorteilhaft lediglich anhand der Ausrichtungsmarken das Ausrichten des Substrathalters beziehungsweise des auf der Substrathalteroberfläche angeordneten Substrates durch ein, insbesondere genau ein, Erfassungsmittel erfolgen.

In der Vorrichtung zum Ausrichten eines Substrates ist vorgesehen, dass die Vorrichtung ferner aufweist:
C) eine Erfassungseinheit zur Erfassung der Ausrichtungsmarken des Ausrichtungsmarkierungsfeldes und
D) eine Bewegungseinrichtung zum Bewegen des Substrathalters,
wobei die Ausrichtungsmarken des Ausrichtungsmarkierungsfeldes in einer ersten Ebene und einer zweiten Ebene angeordnet sind, und wobei die erste Ebene und die zweiten Ebene parallel zueinander angeordnet sind, und wobei die erste Ebene und die zweite Ebene einen Abstand zueinander aufweisen, und wobei eine erste Ausrichtungsmarke der Ausrichtungsmarken der ersten Ebene in einer Fokusposition der Erfassungseinheit erfassbar ist, und wobei die Fokusposition der Erfassungseinheit fixierbar ist, und wobei in der Fokusposition durch die Erfassungseinheit eine zweite Ausrichtungsmarke der Ausrichtungsmarken der zweiten Ebene erfassbar ist, und wobei der Substrathalter senkrecht zu der ersten Ebene durch die Bewegungseinrichtung bewegbar ist.

Die Vorrichtung ist dabei insbesondere so ausgebildet, dass die Fokusposition der Erfassungseinheit unmittelbar nach einem Erfassen der ersten Ausrichtungsmarke der ersten Ebene des Ausrichtungsmarkierungsfeldes fixierbar ist. Die fixierte Fokusposition der Erfassungseinheit legt dabei den scharf abgebildeten Fokusbereich fest. Auf diese Weise kann durch die Bewegungseinrichtung vorteilhaft der Abstand der ersten Ebene zur zweiten Ebene angefahren werden, so dass der Substrathalter beziehungsweise das Substrat anhand des Ausrichtungsmarkierungsfeldes um den Abstand in eine Richtung exakt verfahrbar sind. Die Erfassungseinheit wird zudem vorzugsweise ortsfest gehalten, so dass lediglich durch das Erfassen der Ausrichtungsmarken und ein Bewegen des Substrathalters der Abstand zwischen den Ebenen auf angefahren werden. Wenn die Vorrichtung zum Ausrichten für das Einstellen eines Bondabstandes zwischen zwei zu verbondenden Substraten verwendet wird, ist der Abstand zwischen der ersten Ebene und der zweiten Ebene vorzugsweise der gewünschte Abstand vor der Initiierung eines Bondvorgangs. In anderen Worten entspricht der Bondabstand einem Bondgap. Das Ausrichten mit der Vorrichtung ist dabei vorteilhaft direkt durch die Erfassung der zweiten Ausrichtungsmarke der zweiten Ebene kontrollierbar. Eine direkte Sichtkontrolle durch genau eine Erfassungseinheit kann somit vorteilhaft eine korrekte Ausrichtung verifizieren.

In einer bevorzugten Ausführungsform der Vorrichtung zum Ausrichten eines Substrates ist vorgesehen, dass die Ausrichtungsmarken der ersten Ebene und die Ausrichtungsmarken der zweiten Ebene in dem Ausrichtungsmarkierungsfeld fluchtend übereinander, insbesondere deckungsgleich, angeordnet sind.

Zwischen den Ebenen ist das Ausrichtungsmarkierungsfeld vorzugsweise transparent für die Erfassungseinheit ausgebildet. Durch die fluchtende Anordnung der Ausrichtungsmarkierungen übereinander kann vorteilhaft bei dem Erfassen der zweiten Ausrichtungsmarke festgestellt werden, ob die Bewegung des Substrathalters durch die Bewegungseinrichtung exakt senkrecht zu der ersten Ebene durchgeführt wurde. Dabei weist die Erfassungseinheit in der Fokusposition einen Fokuspunkt auf, zu welchem die jeweilige Lage der zweiten Ausrichtungsmarke zur ersten Ausrichtungsmarke vergleichbar ist. Weiterhin ist denkbar, dass die Ausrichtungsmarke der ersten Ebene zu der entsprechenden fluchtenden Ausrichtungsmarke der zweiten Ebene gedreht oder gespiegelt wird. Dabei weist die Ausrichtungsmarke vorzugsweise eine nicht punktsymmetrische Form beziehungsweise Außenkontur auf, so dass durch Drehung beziehungsweise Spiegelung zumindest Teile dieser Ausrichtungsmarke erfassbar sind.

In einer bevorzugten Ausführungsform der Vorrichtung zum Ausrichten eines Substrates ist vorgesehen, dass die Ausrichtungsmarken der ersten Ebene zu den Ausrichtungsmarken der zweiten Ebene stufenartig versetzt angeordnet sind.

In dieser Ausführungsform kann das Ausrichtungsmarkierungsfeld selbst stufenartig ausgebildet sein, wobei die jeweiligen die Ausrichtungsmarkierungen aufweisenden Ebenen eine Oberfläche des Ausrichtungsmarkierungsfeldes bilden. In diesem Fall ist die Erfassungseinheit vorzugsweise so ausgebildet, dass ohne eine Relativbewegung mehrere Stufen des Ausrichtungsmarkierungsfeldes erfassbar sind. Beispielsweise ist der Fokusbereich des Erfassungsmittels so breit, dass mehrere Stufen erfassbar sind. Denkbar ist auch, dass die Erfassungseinheit mehrere nebeneinander angeordnete Mittel jeweils zur Erfassung einer Stufe aufweist. Beispielsweise kann die Erfassungseinheit über mehrere nebeneinander angeordneten Optiken mit entsprechenden Objektiven verfügen. In diesem Fall wird die Fokusposition aller Erfassungsmittel der Erfassungseinheit nach der Erfassung der ersten Ausrichtungsmarke fixiert. Dabei ist das Ausrichtungsmarkierungsfeld vorzugsweise rund ausgebildet und Übergänge zwischen den Ebenen kreisförmig. In anderen Worten werden die die Ausrichtungsmarkierungen aufweisenden Ebenen ringförmig, wobei die in einem Zentrum angeordnete Ebene eine Kreisform aufweist.

Auf diese Weise kann die Erfassungseinheit vorteilhaft jeweils die Oberfläche beziehungsweise eine nahe der Oberfläche angeordnete Ausrichtungsmarke des Ausrichtungsmarkenfeldes erfassen.

In einer bevorzugten Ausführungsform der Vorrichtung zum Ausrichten eines Substrates ist vorgesehen, dass das Ausrichtungsmarkierungsfeld auf einer der Substrathalteroberfläche abgewandten Rückseite des Substrathalters angeordnet ist.

Das Ausrichtungsmarkierungsfeld kann beispielsweise auf der Rückseite angebracht oder in den Substrathalter eingelassen sein. Zudem kann das Ausrichtungsmarkierungsfeld auch durch den Substrathalter selbst gebildet werden. Vorteilhaft kann die Erfassungseinheit auf der Substrathalteroberfläche abgewandten Rückseite angeordnet werden.

In einer bevorzugten Ausführungsform der Vorrichtung zum Ausrichten eines Substrates ist vorgesehen, dass ein Mittelpunkt des Ausrichtungsmarkierungsfeldes auf der Rückseite des Substrathalters zumindest teilweise mit einem Mittelpunkt der Substrathalteroberfläche fluchtet.

Durch die mittige Anordnung des Ausrichtungsmarkierungsfeldes kann vorteilhaft die Ausrichtung des Substrathalters vorteilhaft genau ausgeführt werden. In dieser Ausführungsform kann zudem vorteilhaft eine lineare Fehlerkomponente oder eine Rotation des Substrathalters und somit der Substrathalteroberfläche relativ zu der Erfassungseinheit wahrgenommen werden. Insbesondere können auch Keilfehler in Bezug auf die Linse der Optik erfasst und behoben werden. Die Ausrichtungsfehler können in Fehlerkomponenten aufgeteilt werden. So können lineare, rotatorische sowie Vergrößerungsfehler und Fehler größerer Ordnung charakterisiert werden.

In einer bevorzugten Ausführungsform der Vorrichtung zum Ausrichten eines Substrates ist vorgesehen, dass das Ausrichtungsmarkierungsfeld auf einer der Substrathalteroberfläche zugewandten Seite des Substrates angeordnet ist.

In dieser Ausführungsform weist der Substrathalter eine Durchgangsöffnung im Bereich des Ausrichtungsmarkierungsfeldes auf. Weiterhin ist denkbar, dass der Substrathalter für die Erfassungseinheit transparent ausgebildet ist, so dass das auf dem Substrat angeordnete Ausrichtungsmarkierungsfeld, insbesondere von der Rückseite des Substrathalters erfassbar ist. Auf diese Weise kann die Sichtkontrolle vorteilhaft direkt an dem auszurichtenden Substrat erfolgen. Dabei wird das Substrat und somit das Ausrichtungsmarkierungsfeld relativ zum Substrathalter ortsfest gehalten. Beispielsweise werden Ausrichtungsfehler auf Grund einer unebenen Substrathalteroberfläche vermieden. Weiterhin kann das Ausrichtungsmarkierungsfeld vorteilhaft individuell an das Substrat angepasst sein. Zudem kann das Ausrichtungsmarkierungsfeld durch das Substrat gebildet werden beziehungsweise abgebildet werden.

In einer bevorzugten Ausführungsform der Vorrichtung zum Ausrichten eines Substrates ist vorgesehen, dass das Ausrichtungsmarkierungsfeld mindestens eine weitere Ebene mit den Ausrichtungsmarken aufweist, wobei die mindestens eine weitere Ebene parallel zu der ersten Ebene und der zweiten Ebene angeordnet ist.

Bevorzugt weist das Ausrichtungsmarkierungsfeld zumindest drei Ebenen mit Ausrichtungsmarken auf. Dabei wird auf den Ausrichtungsmarken die Information bereitgestellt, auf welcher Ebene diese angeordnet sind. Weiterhin können auf diese Weise mehrere bestimmte Abstände durch die Vorrichtung angefahren werden. Die Abstände zwischen den Ebenen können gleich groß sein. Bevorzugt sind die Ebenen jedoch in unterschiedlichen Abständen zueinander angeordnet. Auf diese Weise können flexibel mehrere Abstände angefahren werden. Insbesondere bei der Verwendung der Vorrichtung zum Bonden von Substraten können somit vorteilhaft verschiedene Bondabstände eingestellt beziehungsweise das Substrat zu einem anderen Substrat besonders genau ausgerichtet werden.

In einer bevorzugten Ausführungsform der Vorrichtung zum Ausrichten eines Substrates ist vorgesehen, dass die Vorrichtung mindestens ein weiteres Ausrichtungsmarkierungsfeld und mindestens eine weitere Erfassungseinheit zum Erfassen des mindestens einen weiteren Ausrichtungsmarkierungsfeldes aufweist, wobei das mindestens eine weitere Ausrichtungsmarkierungsfeld ortsfest zu dem Substrathalter angeordnet ist.

Das weitere Ausrichtungsmarkierungsfeld erlaubt eine noch genauere Ausrichtung, da an die Erfassung an mehreren Punkten erfolgt. Beispielsweise können auf diese Weise Verschiebungen und/oder Rotationsfehler besonders gut erkannt und behoben werden. Das Ausrichtungsmarkierungsfeld und das mindestens eine Ausrichtungsmarkierungsfeld sind dabei vorzugsweise entlang des Substrathalters versetzt angeordnet. Besonders bevorzugt weist die Vorrichtung insgesamt drei Ausrichtungsmarkierungsfelder und drei Erfassungseinheiten auf, welche jeweils um einen Mittelpunkt der Substrathalteroberfläche verteilt, insbesondere in radialer Richtung gleichmäßig zueinander versetzt angeordnet sind.

Bevorzugt weisen die jeweiligen Ebenen des Ausrichtungsmarkierungsfeldes und des mindestens einen weiteren Ausrichtungsmarkierungsfeldes zueinander dieselben Abstände auf. Auf diese Weise ist das Ausrichten besonders genau möglich, da an mindestens zwei Punkten, bevorzugt örtlich versetzten Punkten, der Abstand verifizierbar ist.

Ein Kernaspekt der Erfindung ist, dass vor einer Ausrichtung des Substrates das zumindest zwei Ausrichtungsmarken auf mindestens zwei unterschiedlichen Ebenen beziehungsweise Höhen des Ausrichtungsmarkierungsfeldes erfasst werden. Das Ausrichtungsmarkierungsfeld ist dabei vorzugsweise an einem der auszurichtenden Substrate oder am Substrathalter angebracht. Die Ausrichtungsmarken stellen dabei jeweils eine 3D-Positionsinformation für die Ausrichtung der Substrate bereit. Bevorzugt ist das Ausrichtungsmarkierungsfeld nicht an den Kontaktflächen der Substrate angeordnet. Vorzugsweise ist das Ausrichtungsmarkierungsfeld an einer von der Kontaktfläche abgewandten oder zur Kontaktfläche parallel angeordneten Seite des Substrats oder des Substrathalters angeordnet.

Die Ausrichtung der Substrate zueinander erfolgt insbesondere mittelbar an Hand von Ausrichtungsmarkierungen, die an Kontaktflächen der Substrate befinden. Die Ausrichtungsmarkierungen an gegenüberliegenden Seiten der gegenüberliegenden Substrate sind insbesondere komplementär zueinander. Ausrichtungsmarkierungen können jegliche, zueinander ausrichtbare Objekte wie Kreuze, Kreise oder Quadrate oder propellerartige Gebilde oder Gitterstrukturen, insbesondere Phasengitter für den Ortsfrequenzbereich sein.

In einer besonders vorteilhaften Ausführungsform der Vorrichtung können Ausrichtungsmarkierungen zumindest teilweise QR-Code beinhalten, welche insbesondere eine absolute, maschinenlesbare Positionskodierung (x, y, z-Position) der jeweiligen Ausrichtungsmarke beschreiben.

In einer weiteren besonders vorteilhaften Ausführungsform können Ausrichtungsmarkierungen zumindest teilweise alphanumerischen Zeichen beinhalten, welche insbesondere eine absolute, maschinenlesbare Positionskodierung (x, y, z- Position) der jeweiligen Ausrichtungsmarke beschreiben.

Die Ausrichtungsmarkierungen und/oder Ausrichtungsmarkierungsfelder werden mit Vorzug mittels elektromagnetischer Strahlung bestimmter Wellenlänge und/oder Wellenlängenbereiche erfasst. Diese umfassen beispielsweise Infrarotstrahlung, sichtbares Licht oder ultraviolette Strahlung. Die Verwendung von Strahlung kürzerer Wellenlänge, wie EUV (extrem ultraviolette Strahlung) oder Röntgenstrahlung ist ebenfalls möglich.

Ein besonders wichtiger Aspekt der vorliegenden Erfindung ist es, dass die Ausrichtung und Einstellung des Bondabstandes, insbesondere ausschließlich, mittels der Erfassung der übereinander angeordneten Ausrichtungsmarken des Ausrichtungsmarkierungsfeldes erfolgt. Mit ausschließlich ist gemeint, dass die zusätzlichen Ausrichtungsmarkierungen während der Ausrichtung nicht erfasst werden oder erfassbar sind. Ein Bondabstand kann daher durch die übereinander angeordneten Ausrichtungsmarken genau und unter Sichtkontrolle eingestellt werden.

Dabei beinhalten das Ausrichtungsmarkierungsfeld bevorzugt eindeutig zugeordnete und/oder zuordenbare Ausrichtungsmarkierungen beziehungsweise Ausrichtungsmarken in zumindest zwei unterschiedlichen Ebenen. Dabei weist das Ausrichtungsmarkierungsfeld Stufen oder zumindest teils transparenten Schichten auf, so dass die Ausrichtungsmarken übereinander angeordnet sind. Somit wird neben der üblichen x-y Position auch indirekt eine Höheninformation bereitgestellt. Dabei können die Ausrichtungsmarken des Ausrichtungsmarkierungen auch direkt eine 3D-Positionsinformation bereitstellen. Die Höheninformation wird durch die Anordnung in unterschiedlichen Ebenen bereitgestellt. Da die Abstände zwischen den Ebenen bekannt sind, reicht somit insbesondere die Bereitstellung der Information auf welcher Ebene die erfasste Ausrichtungsmarke in dem Ausrichtungsmarkierungsfeld angeordnet ist.

Das Ausrichtungsmarkierungsfeld besteht aus beziehungsweise umfasst somit positionskodierten und höhenkodierten Ausrichtungsmarkierungen, welche ohne Refokussierung der dritten Erfassungseinheit eine eindeutige Positionsinformationen und Höheninformationen der Substrate und/oder des Substrathalters zur Ausrichtung liefern. Die Ausrichtungsmarkierungen beziehungsweise Ausrichtungsmarken des Ausrichtungsmarkierungsfeldes soll im Folgenden auch ohne explizite Nennung der Höhenkodierung und/oder 3D-Positionsinformation als höhenkodierte Ausrichtungsmarkierungen beziehungsweise Ausrichtungsmarken verstanden werden.

Bevorzugt ist die Größe beziehungsweise die Dimensionierung des Ausrichtungsmarkierungsfeldes an das jeweilige Blickfeld der optischen Erfassungsmittel angepasst, sodass jeweils mindestens zwei Stufen oder Ausrichtungsmarkierungsebenen betrachtet werden können. Die Anzahl der Stufen und die Gesamthöhe des Ausrichtungsmarkierungsfeldes ist dabei ebenfalls auf den Abstand, welcher eingestellt werden soll, abgestimmt. Soll beispielsweise ein Bondabstand von 500 Mikrometer eingestellt werden, werden bevorzugt 550 Mikrometer höhenkodierte Positionsinformation im Ausrichtungsmarkierungsfeld abgebildet, um ohne Refokussierung den Abstand anfahren zu können.

Die Erfassung erfolgt bevorzugt mit entsprechenden abbildenden optischen Systemen, sodass die Abbildungstiefe so gewählt werden kann, dass diese geringer ist als die Stufenhöhe oder eine Schichtdicke des Ausrichtungsmarkierungsfeldes. Die Abbildungstiefe (eng: depth of focus, DOF) ist derjenige Bereich im Bildraum eines abbildenden optischen Systems, in dem ein hinreichend scharfes Bild eines fokussierten Objektes, insbesondere einer Ausrichtungsmarkierung entsteht. Im Umkehrschluss bedeutet dies, dass die Bildebene (ein Bilderfassungsmittel, Sensor) im Bereich der Abbildungstiefe verschoben werden kann, ohne dass das Bild eines Objektes merklich unscharf wird.

Erfolgt die Erfassung einer Ausrichtungsmarke des Ausrichtungsmarkierungsfeldes mit einer geringen Abbildungstiefe, welche kleiner ist als die Stufenhöhe, bevorzugt kleiner ist, als die halbe Stufenhöhe, besonders bevorzugt kleiner ist, als 0,1 Stufenhöhe, kann eindeutig die Position des Ausrichtungsmarkierungsfeldes insbesondere in der z-Richtung bestimmt werden.

Die Abbildungstiefe der Erfassungsmittel beträgt weniger als 50 Mikrometer, bevorzugt weniger als 20 Mikrometer, besonders bevorzugt weniger als 10 Mikrometer, ganz besonders bevorzugt weniger als 5 Mikrometer, im optimalen Fall weniger als 4 Mikrometer.

Wenn hingegen die Abbildungstiefe ausreicht mindestens zwei Stufenhöhen scharf abzubilden, wird die Positionierungsunsicherheit der Vorrichtung erhöht, denn damit kann keine eindeutige Zuordnung einer z-Höhe zu einer Stufe erfolgen.

In einer bevorzugten Ausführungsform der Vorrichtung kann ein Bilderfassungsmittel beziehungsweise ein Erfassungsmittel der Erfassungseinheit um 0,2 Stufenhöhen ohne bildseitige Refokussierung reproduzierbar verschoben werden. Dies kann dazu verwendet werden zu bestimmen, welche Ausrichtungsmarkierung des Ausrichtungsmarkierungsfeldes für die Positionierung verwendet werden sollen, wenn die bildseitige Fokusebene direkt auf der Höhe zwei angrenzender Stufen liegt und beide Stufen gleich scharf erscheinen. Es kann mit der geringen Verschiebung des Bilderfassungsmittels eine Entscheidung (auch als ein rechnerimplementiertes, eigenständiges, erfindungsmäßiges Verfahren) der zu verwendenden Ausrichtungsmarkierungen getroffen werden.

Physikalisch bedingt wird bei der Erfassung des Ausrichtungsmarkierungsfeldes jeweils nur eine Ebene beziehungsweise Stufe scharf abgebildet. Insoweit liegt bevorzugt jeweils nur eine Stufe beziehungsweise Ebene im Fokusbereich der Erfassungseinheit. Da die Ausrichtungsmarkierungen des Ausrichtungsmarkierungsfeldes positions- und ortskodiert sind, kann aus einer scharf erfassten Ausrichtungsmarke einer Ebene eine Positionsinformation insbesondere des Substrathalters in einem räumlichen Koordinatensystem bestimmt werden.

Gemäß einer vorteilhaften Ausführungsform der Erfindung ist das erste Substrat und das zweite Substrat zwischen dem ersten Substrathalter und dem zweiten Substrathalter mit einem Abstand A zwischen der ersten Kontaktfläche und der zweiten Kontaktfläche in einer Z-Richtung angeordnet. Der Abstand A beträgt insbesondere weniger als 500 Mikrometer, bevorzugt weniger als 100 Mikrometer, besonders bevorzugt weniger als 50 Mikrometer, am bevorzugtesten weniger als 10 Mikrometer.

Das Verfahren zum Ausrichten eines Substrates ist dazu geeignet mindestens zwei Substrate mit einer beliebigen elektromagnetischen Strahlung, insbesondere mit UV-Licht, bevorzugter mit Infrarotlicht, am bevorzugtesten mit sichtbarem Licht zueinander auszurichten. Dabei kann das auszurichtenden beziehungsweise das auf der Substrathalteroberfläche des Substrathalters angeordnete Substrat auch relativ zu anderen Bauteilen um den Abstand zwischen den Ebenen genau bewegt werden und somit ausgerichtet werden.

Das Verfahren ermöglicht die Betrachtung beziehungsweise Erfassung der ersten und zweiten Ausrichtungsmarkierungen, wobei eine Ergänzung mit mindestens einem zusätzlichen optischen Pfad für die genaue Wiederherstellung der Substrat- und Substrathalterposition vorgesehen ist, der bei der Ausrichtung der Substrate nicht zwischen den Substraten angeordnet ist oder verläuft, sondern eine Erfassung von außerhalb ermöglicht, insbesondere mit der Beobachtung beziehungsweise Erfassung zumindest eines Ausrichtungsmarkierungsfeldes. Das Ausrichtungsmarkierungsfeld stellt dabei bevorzugt zwischen der ersten Ebene und der zweiten Ebene die Höheninformation für die Einstellung eines gewünschten Bondabstandes bereit.

In einem besonders bevorzugten Verfahren kann ein Substrat für die elektromagnetische Strahlung, welche für die Erfassung der Ausrichtungsmarkierungen eines ersten und zweiten Substrates verwendet wird, intransparent sein. Dabei erfolgt die Erfassung der Ausrichtungsmarkierungen durch die Rückseite des Substrats, welches für die elektromagnetische Strahlung, welche für die Erfassung der Ausrichtungsmarkierungen verwendet wird, transparent ist.

Das Verfahren zum Ausrichten erhöht die Ausrichtungsgenauigkeit insbesondere mittels der weiteren X-Y-Z-Positions- und/oder Lageinformationen, welche mit weiteren Ausrichtungsmarkierungsfeldern und entsprechenden weiteren Erfassungseinheiten erfasst und zur Steuerung und/oder Regelung der Ausrichtung verwendet werden.

Hierfür weist die Vorrichtung zum Ausrichten bevorzugt eine, insbesondere softwaregestützte, Steuerungseinheit auf, mittels der die hier beschriebenen Schritte durchgeführt und Bauteile gesteuert werden. Dabei sollen geschlossene Regelkreise sowie Regelungen unter der Steuerungseinheit subsummiert verstanden werden.

Mit X- und Y-Richtung oder X- und Y-Position werden in einem X-Y-Koordinatensystem beziehungsweise in einer beliebigen Z-Ebene des X-Y-Koordinatensystems verlaufende Richtungen oder angeordnete Positionen verstanden. Die Z-Richtung ist zur X-Y-Richtung orthogonal angeordnet. Die X- und Y-Richtung entspricht insbesondere einer lateralen Richtung, vorzugsweise entlang der Ebenen des Ausrichtungsmarkierungsfeldes. Die Z-Richtung ist vorzugsweise die Richtung, in die der Substrathalter bewegt wird, wenn die Fokusposition der Erfassungseinheit in der X-Y-Ebene fixiert ist.

Positionsmerkmale werden aus den Positions- und/oder Lagewerten der Ausrichtungsmarkierungen der Substrate sowie von Ausrichtungsmarkierungen auf dem Substrathalter, insbesondere durch die Erfassung und Auswertung des Ausrichtungsmarkierungsfeldes berechnet beziehungsweise erfasst.

Das Ausrichtungsmarkierungsfeld befindet sich vorzugsweise in örtlicher Nähe zu den Ausrichtungsmarkierungen der Substrate. Besonders bevorzugt sind zumindest eine Ausrichtungsmarkierungen der Substrate und das Ausrichtungsmarkierungsfeld auf gegenüberliegenden Seiten des Substrates angeordnet. Auch kann das Ausrichtungsmarkierungsfeld auf der Rückseite des Substrathalters und gegenüber von den zusätzlichen Ausrichtungsmarkierungen angeordnet sein. Sind die zusätzlichen Ausrichtungsmarken und die Ausrichtungsmarken des Ausrichtungsmarkierungsfeldes auf gegenüber liegenden Seiten der Substrathalteroberfläche angeordnet, kann eine Korrelierung der Lage besonders einfach erfolgen.

In einer besonders bevorzugten Ausführungsform befindet sich zumindest ein Ausrichtungsmarkierungsfeld vorzugsweise in z-Richtung fluchtend zu den zusätzlichen Ausrichtungsmarkierungen der Substrate, vorzugsweise auf einer Rückseite des Substrathalters.

In einer weiteren bevorzugten Ausführungsform der Vorrichtung befindet sich zumindest ein Ausrichtungsmarkierungsfeld vorzugsweise in z-Richtung fluchtend zum Zentrum des Substrates beziehungsweise zu dem Mittelpunkt der Substrathalteroberfläche, insbesondere auf einer Rückseite des Substrathalters.

In einer ganz besonders bevorzugten Ausführungsform der Vorrichtung befinden sich zwei Ausrichtungsmarkierungsfelder vorzugsweise jeweils fluchtend in z-Richtung zu den zusätzlichen Ausrichtungsmarkierungen der Substrate, insbesondere an einer Rückseite des Substrathalters.

In einer weiteren bevorzugten Ausführungsform der Vorrichtung befindet sich zumindest ein Ausrichtungsmarkierungsfeld auf der Substratseite des Substrathalters beziehungsweise auf der Seite der Substrathalteroberfläche, in der Nähe des Substrates, für die optische Erfassung zugänglicher Position.

Eine weiterführende Ausführungsform der Vorrichtung beinhaltet mindestens zwei Ausrichtungsmarkierungsfelder auf der Substratseite des Substrathalters in der Nähe des Substratrandes, für die optische Erfassung zugänglicher Position. Somit kann vorteilhaft eine Nivellierung des Substrathalters durchgeführt werden.

Das Verfahren zum Ausrichten und die Vorrichtung zum Ausrichten weisen somit insbesondere mindestens eine zusätzliche Erfassungseinheit mit einem entsprechenden Mess- und/oder Regelsystem und mindestens ein zusätzliches Ausrichtungsmarkierungsfeld auf, wobei durch zusätzliche Messwerte und Korrelationen mit mindestens einem der Messwerte der zusätzlichen Erfassungseinheiten die Ausrichtungsgenauigkeit, insbesondere ohne Refokussierung, bevorzugt ohne bildseitige Refokussierung weiter erhöht wird.

Durch die Korrelation mindestens einer der vermessenen zusätzlichen Ausrichtungsmarkierungen, insbesondere auf den Kontaktflächen, eines ersten Substrats und/oder zweiten Substrats mit zumindest einer Ausrichtungsmarke des Ausrichtungsmarkierungsfeldes, welche auch bei der Ausrichtung der Substrate frei zugänglich und sichtbar ist, wird die direkte Beobachtbarkeit einer Ausrichtungsmarke und somit eine Echtzeitmessung und Regelung während der Ausrichtung ermöglicht. Somit steigt die Ausrichtungsgenauigkeit der Substrate.

Ein weiterer Vorteil des Ausrichtungsmarkierungsfeldes ist die Erfassung der zusätzlichen Höheninformation, sodass der untere Substrathalter mit dem unteren Substrat genauer zum oberen Substrat auf einem oberen Substrathalter positioniert werden kann. Es entfallen somit insbesondere die resultierenden Positionsungenauigkeiten der Fokussierbewegung der Erfassungseinheit.

Durch die erhöhte Genauigkeit der Höhenpositionierung des Abstandes des oberen Substrats zum unteren Substrat beim Bonden wird die Vorspannung zumindest eines der Substrate mit geringer Toleranz eingestellt, welche die Verzerrungen des Substrats beim Bonden reduziert, sodass das Run-out der Substrate nach dem Bonden zumindest vermindert, bevorzugt eliminiert wird. Insoweit ist das Verfahren zum Ausrichten und die Vorrichtung zum Ausrichten für ein Ausrichten bei einem Bondvorgang prädestiniert.

In einer weiterführenden Ausführungsform der Vorrichtung ist mindestens ein weiteres Ausrichtungsmarkierungsfeld auf der Substratseite eines Substrathalters Nahe des Umfangsrandes des Substrats in einer Position, welche dauerhaft für eine weitere Erfassungseinheit zugänglich ist, positioniert. Besonders bevorzugt befindet sich eine Oberfläche des Ausrichtungsmarkenfeldes in derselben Ebene, wie die zu bondende Oberfläche des auf dem Substrathalter befestigten Substrats.

Zwischen dem zusätzlich hinzugefügten 3D-Positionsmerkmal auf dem Substrathalter und den Positionsmerkmalen auf den Substraten wird insbesondere eine eindeutige Korrelation hergestellt, die vorzugsweise während der Ausrichtung nicht verändert wird und bis die Substrate zueinander gebondet sind, beibehalten wird.

Durch die zusätzlich hinzugefügten 3D-Positionsmerkmale am Substrathalter, die eindeutig mit den Positionsmerkmalen auf dem Substrat korrelierbar sind, kann eine direkte Beobachtung der Ausrichtungsmarkierungen auf dem Substrat durch eine direkte Beobachtung der Ausrichtungsmarkierung am Substrathalter ersetzt werden. Dies hat den Vorteil, dass der beobachtbare Teil des Substrathalters praktisch immer im Sichtfeld beziehungsweise in einem Erfassungsbereich der Erfassungseinheit angeordnet werden kann. Durch die 3D-Positionsinformation kann die Ausrichtung der Substrate zueinander mit erhöhter Genauigkeit durchgeführt werden.

Bevorzugt beträgt ein Erfassungsbereich einer Erfassungseinheit eine Fläche kleiner 3 mm x 3 mm, bevorzugt kleiner 2 mm x 2 mm, besonders bevorzugt kleiner 1 mm x 1 mm.

Eine aktive Rückführung der Daten für die Positionierung und Positionskorrektur erhöht die Genauigkeit im Vergleich zu einer gesteuerten Positionierung im Stand der Technik, da in geschlossenen Regelkreisen eine Kontrollmöglichkeit des Ist-Standes der Position gegeben ist.

Ein Aspekt des Verfahrens und der Vorrichtung zum Ausrichten ist die Erhöhung der Genauigkeit der Ausrichtung zweier Substrate. Mit dem Verfahren zum Ausrichten kann, insbesondere von außerhalb des Bondinterface in Echtzeit, die Ausrichtung beziehungsweise Bewegung beobachtet werden. Durch die integrierte 3D-Positionsinformation mit der bereitgestellten Höheninformation kann noch genauer ausgerichtet werden als mit bisher bekannten Verfahren. Hierbei werden die Substrate insbesondere mit minimalem Abstand zueinander angeordnet und zwischen den Substraten befindet vorzugsweise sich kein Vorrichtungsgegenstand insbesondere keine Erfassungseinheit.

Es wird eine Korrelation der zusätzlichen Ausrichtungsmarkierungen eines ersten Substrats und/oder eines zweiten Substrats auf der jeweiligen Kontaktflächen der Substrate mit zumindest einer Ausrichtungsmarke des Ausrichtungsmarkierungsfeldes hergestellt. Die Ausrichtungsmarke des Ausrichtungsmarkierungsfeldes ist während der Ausrichtung, insbesondere direkt, durch die Erfassungseinheit erfassbar.

Die direkte Erfassbarkeit beziehungsweise Beobachtbarkeit der mindestens einen Ausrichtungsmarke des Ausrichtungsmarkierungsfeldes ermöglicht eine Echtzeitmessung der 3D-Position des Substrathalters. Dabei wird die Ausrichtungsgenauigkeit erhöht, weil mit der

Erfassung der ersten und der zweiten Ausrichtungsmarke und der damit bereitgestellten Höheninformation Positionierunsicherheiten wegfallen, wodurch die Fehlerfortpflanzung reduziert wird. Durch diese Maßnahme wird die Ausrichtungsgenauigkeit durch die Reduzierung der Anzahl der notwendigen Zustellbewegungen und geregelte Höhenverstellung beim Bonden verbessert.

Eine erste Ausführungsform der Vorrichtung zum Ausrichten wird in einer Bondvorrichtung eingesetzt und beinhaltet einen oberen Substrathalter. Auf dem oberen Substrathalter kann ein oberes Substrat befestigt werden. Der obere Substrathalter ist zumindest lokal ausreichend transparent ausgeführt, sodass die Ausrichtungsmarkierungen des oberen Substrats auf der Kontaktfläche des oberen Substrats, welche der Auflagefläche des oberen Substrats abgewandte Fläche ist, in ausreichender Auflösung und Kontrast und Intensität erfassbar sind.

Dazu ist das obere Substrat für die Strahlung, welche zur Erfassung einer ersten zusätzlichen Ausrichtungsmarkierung des oberen Substrats verwendet wird, ausreichend transparent.

Unter ausreichend transparentes Substrat wird verstanden, dass die Transmittanz des Substrats für die elektromagnetische Strahlung, mit welcher die zusätzlichen Ausrichtungsmarkierung erfasst werden, ausreicht, die zusätzlichen Ausrichtungsmarkierung in ausreichender Auflösung und Kontrast und Intensität zu erfassen.

Unter lokal ausreichend transparentes Substrathalter wird verstanden, dass die Transmittanz des Substrathalters für die elektromagnetische Strahlung, mit welcher die Ausrichtungsmarkierung erfasst wird, ausreichend hoch ist. Alternativ können Sichtfenster und/oder Durchgangsöffnungen für die Betrachtung des Substrats und/oder Substratpaares im Substrathalter angebracht sein.

Während der Erfassung der zusätzlichen Ausrichtungsmarkierung auf den Substraten werden das insbesondere obere Substrat und der obere Substrathalter aus dem Fokus der zusätzlichen Erfassungseinheit herausgefahren.

Dabei kann durch den oberen Substrathalter und durch das obere Substrat hindurch die zusätzliche Ausrichtungsmarkierung auf dem insbesondere unteren Substrat beziehungsweise auf dem unteren Substrathalter erfasst werden.

Während der Erfassung der zusätzlichen Ausrichtungsmarkierung wird zumindest eine Ausrichtungsmarke des Ausrichtungsmarkierungsfeldes insbesondere auf der Rückseite des Substrathalters korreliert, um eine 3D-Positionsinformation des Substrathalters, insbesondere des unteren Substrathalters, zu ermitteln.

Die Erfassungseinheit zur Erfassung des Ausrichtungsmarkierungsfeldes ist insbesondere Teil eines optischen Systems zur Erfassung des Ausrichtungsmarkierungsfeldes und beinhaltet gemäß einer vorteilhaften Ausführungsform Strahlformungs- und/oder Umlenkungselemente wie Spiegel, Linsen, Prismen, Strahlungsquellen insbesondere zur Köhlerschen Beleuchtung sowie Bilderfassungsmittel wie Kameras (CMOS-Sensoren, oder CCD, oder Flächen- oder Zeilen- oder Punkterfassungsmittel wie ein Fototransistor) und Bewegungsmittel zur Fokussierung sowie Auswertemittel zur Regelung des optischen Systems.

In einer weiteren Ausführungsform der Vorrichtung kann das optische System in Kombination mit einem Rotationssystem für die Substratpositionierung nach dem Prinzip der Umschlagsjustierung verwendet werden (vgl. dazu Hansen, Friedrich: Justierung, VEB Verlag Technik, 1964, Abs. 6.2.4, Umschlagmethode). Demnach wird bei der Umschlagsjustierung mindestens eine Messung in einer definierten Position des jeweiligen Substrates und mindestens eine Messung in 180 Grad gedrehter, entgegengesetzt orientierter, umgeschlagener Position durchgeführt. Das so erhaltene Messergebnis ist insbesondere von Exzentrizitätsfehlern bereinigt.

Eine Weiterbildung der Vorrichtung zum Ausrichten beinhaltet zwei, insbesondere identische, baugleiche optische Systeme mit zueinander ausgerichteten und relativ zueinander fixierbaren zusätzlichen Erfassungseinheiten zur Erfassung von zusätzlichen Ausrichtungsmarken.

In einer weiteren Ausführungsform der Vorrichtung zum Ausrichten wird mindestens ein Substrathalter verwendet, welcher an definierten Stellen für die insbesondere gleichzeitige Beobachtung beider Substratseiten mindestens teilweise, bevorzugt über 95%, transparent ist.

In einer weiteren Ausführungsform der Vorrichtung wird mindestens ein Substrathalter verwendet, welcher an definierten Stellen für die insbesondere gleichzeitige Beobachtung beider Substratseiten Öffnungen und/oder Durchbrüche und/oder Sichtfenster aufweist.

Weiterhin kann eine Vorrichtung ein System zur Herstellung von Pre-bonds beinhalten. Dazu können für das Fügen von Substraten Druckstäbe (engl. Pin) und/oder einstellbare Düsen zur Initiierung des Fusionsbondes verwendet werden. Insbesondere können die einstellbaren Düsen höhenverstellbar sein, sodass die relative Position zur Substratrückseite verändert werden kann und der Volumenstrom der Düse geregelt veränderbar ist. Die Ausrichtung dieser kann vorteilhaft anhand der übereinander angeordneten Ausrichtungsmarkierungen erfolgen.

Weiterhin beinhaltet eine Vorrichtung vorzugsweise Bewegungseinrichtungen mit Antriebssystemen, Führungssystemen, Festhaltungen sowie Messsystemen, um zumindest die Erfassungseinheit und den Substrathalter und damit das auszurichtende Substrat zu bewegen, zu positionieren und genau auszurichten.

Die Bewegungseinrichtungen können jede Bewegung als Resultat von Einzelbewegungen erzeugen, sodass die Bewegungseinrichtungen bevorzugt schnelle, den Genauigkeitsanforderungen nicht entsprechende Grobpositioniervorrichtungen sowie präzise arbeitende Feinpositioniervorrichtungen enthalten können.

Als Grobpositioniervorrichtung wird eine Positioniervorrichtung verstanden, wenn die Anfahr- und/oder Wiederholgenauigkeit vom Sollwert mehr als 0,1%, bevorzugt mehr als 0,05%, besonders bevorzugt mehr als 0,01 %, bezogen auf den gesamten Verfahrweg oder Rotationsbereich, bei umlauffähigen Rotationsantrieben eine volle Umdrehung von 360 Grad, abweicht.

Beispielsweise resultiert somit bei einer Grobpositioniervorrichtung mit einem Verfahrweg von über 600 mm (Doppeltes vom Substratdurchmesser) eine Anfahrgenauigkeit von 600 mm * 0,01%, also mehr als 60 Mikrometer als Restunsicherheit.

In anderen Ausführungsformen der Grobpositionierung ist die Restunsicherheit der Anfahr- oder Wiederholgenauigkeit weniger als 100 Mikrometer, bevorzugt weniger als 50 Mikrometer, besonders bevorzugt weniger als 10 Mikrometer. Dabei sollen die thermischen Störgrößen ebenfalls berücksichtigt werden.

Eine Grobpositioniervorrichtung erfüllt die Positionieraufgabe nur dann mit hinreichender Genauigkeit, falls zwischen der tatsächlich erreichten Ist-Position und dem Sollwert der Position die Abweichung im Verfahrbereich einer zugeordneten Feinpositioniervorrichtung liegt.

Eine alternative Grobpositioniervorrichtung erfüllt die Positionieraufgabe nur dann mit hinreichender Genauigkeit, falls zwischen der tatsächlich erreichten Ist-Position und dem Sollwert der Position die Abweichung im halben Verfahrbereich einer zugeordneten Feinpositioniervorrichtung liegt.

Als Feinpositioniervorrichtung wird eine Positioniervorrichtung verstanden, wenn die Restunsicherheit der Anfahr- und/oder Wiederholgenauigkeit vom Sollwert weniger als 500 ppb, bevorzugt weniger als 100 ppb, bevorzugter 1 ppb bezogen auf den gesamten Verfahrweg oder Rotationsbereich nicht überschreitet.

Vorzugsweise wird eine Feinpositioniervorrichtung einen absoluten Positionierfehler kleiner 5 Mikrometer, bevorzugt kleiner 1 Mikrometer, kompensieren.

Die Ausrichtung der Substrate zueinander kann in allen sechs Bewegungsfreiheitsgraden erfolgen: drei Translationen gemäß der Koordinatenrichtungen x, y und z sowie drei Rotationen um die Koordinatenrichtungen. Dabei können die Bewegungen in jeglicher Richtung und Orientierung durchgeführt werden. Die Ausrichtung der Substrate beinhaltet insbesondere einen passiven oder aktiven Keilfehlerausgleich, vorzugsweise gemäß der Offenbarung in der Druckschrift EP2612109B1.

Roboter zum Substrathandling werden als Bewegungseinrichtungen subsummiert. Die Festhaltungen können in den Bewegungseinrichtungen bauteilintegriert oder funktionsintegriert sein.

Weiterhin beinhaltet die Vorrichtung zum Ausrichten vorzugsweise Regelungssysteme und/oder Auswertungssysteme, insbesondere Rechner, um die beschriebenen Schritte, insbesondere Bewegungsabläufe auszuführen, Korrekturen durchzuführen, Betriebszustände der Vorrichtung zu analysieren und zu speichern.

Verfahren werden vorzugsweise als Rezepte erstellt und in maschinenlesbarer Form ausgeführt. Rezepte sind optimierte Wertesammlungen von Parametern, die im funktionalen oder verfahrenstechnischen Zusammenhang stehen. Die Nutzung von Rezepten erlaubt es, eine Reproduzierbarkeit von Produktionsabläufen zu gewährleisten.

Weiterhin beinhaltet eine Vorrichtung zum Ausrichten gemäß einer vorteilhaften Ausführungsform Versorgungs- sowie Hilfs- und/oder Ergänzungssysteme (Druckluft, Vakuum, elektrische Energie, Flüssigkeiten wie Hydraulik, Kühlmittel, Heizmittel, Mittel und/oder Vorrichtungen zur Temperaturstabilisierung, elektromagnetische Abschirmung).

Weiterhin kann die Vorrichtung zum Ausrichten Gestelle, Verkleidungen, schwingungsunterdrückende oder -dämpfende oder -tilgende aktive oder passive Subsysteme aufweisen.

Weiterhin beinhaltet eine Vorrichtung zum Ausrichten bevorzugt mindestens ein Messsystem, bevorzugt mit Messeinheiten für jede Bewegungsachse, welche insbesondere als Weg-Messsysteme und/oder als Winkel-Messsysteme ausgeführt werden können. Das Messsystem umfasst bevorzugt mindesten eine Erfassungseinheit oder eine zusätzliche Erfassungseinheit.

Es können sowohl taktile, also tastende oder nicht-taktile Messverfahren verwendet werden. Die Messnormale, die Einheit der Messung kann als physikalisch-körperliches Objekt, insbesondere als ein Maßstab vorliegen oder im Messverfahren implizit vorhanden sein, wie die Wellenlänge der verwendeten Strahlung vorliegen.

Für das Erreichen der Ausrichtungsgenauigkeit kann mindestens eines der folgenden Messsystem ausgewählt und verwendet werden. Messsysteme setzen Messverfahren um. Es können insbesondere
- Induktive Verfahren und/oder
- Kapazitive Verfahren und/oder
- Resistive Verfahren und/oder
- Vergleichsverfahren, insbesondere optische Bilderkennungsverfahren, Erfassung von Positionsmarken und/oder QR-Codes und/oder
- inkrementelle oder absolute Verfahren (mit insbesondere Glasnormale als Maßstab, oder Interferometer, insbesondere Laserinterferometer, oder mit magnetischer Normale) und/oder
- Laufzeitmessungen (Dopplerverfahren, time of flight-Verfahren) oder andere Zeiterfassungsverfahren und/oder
- Triangulationsverfahren, insbesondere Lasertriangulation,
- Autofokusverfahren und/oder
- Intensitätsmessverfahren wie faseroptische Entfernungsmesser verwendet werden.

Weiterhin beinhaltet eine besonders bevorzugte Ausführungsform der Vorrichtung zum Ausrichten mindestens ein Messsystem, welches die X-Y-Z-Position und/oder Ausrichtungslage und/oder Winkellage mindestens eines der Substrate und/oder eines der Substrathalters im Bezug zu einer definierten Referenz, insbesondere zum Gestell erfasst. Das Messsystem umfasst zumindest eine Erfassungseinheit.

Dabei werden mit dem Messsystem beziehungsweise mit der Erfassungseinheit des Messsystems 3D-Positionen des Substrats oder bevorzugt des Substrathalters ohne Refokussierung ermittelt, sodass zur ebenen Positionsangaben aus der Messung die Höheninformation ermittelbar ist. Dazu wird zumindest ein Ausrichtungsmarkierungsfeld bestehend aus Stufen und/oder Schichten mit eindeutigen Positionsmarkierungen erfasst.

Als Gestell kann eine, insbesondere aus Naturhartgestein oder Mineralguss oder Kugelgraphitguss oder hydraulisch gebundenem Beton bestehender Teil, welche insbesondere schwingungsgedämpft und/oder schwingungsisoliert und/oder mit Schwingungstilgung aufgestellt ist, verstanden werden.

Durch Anbringung der Erfassungseinheiten an dem Substrathalter und Anbringung von dem Ausrichtungsmarkierungsfeld beispielsweise am Gestell ist eine Umkehrung der Idee ebenfalls vorteilhaft durchführbar. In diesem Fall wird die Erfassungseinheit mit dem Substrathalter bewegt und das Ausrichtungsmarkierungsfeld ist am Gestell fixiert.

Damit eine Erfassung, Auswertung und Steuerung zu einem beliebigen Zeitpunkt, insbesondere dauerhaft, erfolgen kann, werden die Ausrichtungsmarken des Ausrichtungsmarkierungsfeldes gemäß einer vorteilhaften Ausführungsform auf einer größeren Fläche der jeweiligen Ebene als das Blickfeld eines Bilderfassungssystems der Erfassungseinheiten verteilt, um die Steuereinheit (und/oder Regeleinheit), insbesondere kontinuierlich, mit Messwerten zu versorgen. Dabei werden jedoch zu jeder Position im Blickfeld eines Bilderfassungssystems die Ausrichtungsmarken des Ausrichtungsmarkierungsfeldes so ausgelegt, dass die Höheninformation aus dem Ausrichtungsmarkierungsfeld und/oder aus der erweiterten ebenen Positionsinformation erfassbar wird. Mit anderen Worten kann bei jeder lateralen Position des Substrathalters durch die Anordnung der Ausrichtungsmarkierungen des Ausrichtungsmarkierungsfeldes die räumliche Position des Substrathalters erfasst werden und der korrekte Bondabstand eingestellt werden. Da die Position insbesondere des Substrathalter als 3D-Positionsinformation vorliegt, kann eine genauere räumliche Ausrichtung der darauf befestigten Substrate zueinander durchgeführt werden.

In einer vorteilhaften Ausführungsform der Vorrichtung zum Ausrichten sind die zusätzlichen Ausrichtungsmarkierungen auf der Kontaktfläche eines Substrats, bis auf eine Randzone (edge exclusion zone) des Substrats, insbesondere gleichmäßig, verteilt. Mit anderen Worten können somit die zusätzlichen Ausrichtungsmarkierungen des Substrats, welche in einem Abstand weniger 3 mm bevorzugt weniger 2 mm, besonders bevorzugt weniger 500 Mikrometer zueinander positioniert sind verwendet werden, um eine Ausrichtung durchzuführen. Durch die Korrelation der zusätzlichen Ausrichtungsmarkierungen des Substrats mit einem räumlich definierten Ausrichtungsmarkierungsfeld eines Substrathalters können so insbesondere erhöhte lokale Ausrichtungsgenauigkeiten erreicht werden.

Für eine X-Y-Z-Positionsbestimmung kann in der Vorrichtung zum Ausrichten zudem mindestens ein Dreistrahl-Interferometer mit einem entsprechend ausgebildeten, insbesondere monolithischen, Reflektor für die Erfassung der X-Y-Z-Position- und/oder Lagebestimmung des Substrathalters verwendet werden. Eine mögliche weitere vorteilhafte Ausführungsform einer Vorrichtung kann einen prismatischen, monolithischen Reflektor mit mehreren, insbesondere Dreistrahl-Interferometern vermessen werden. So können die Fehlerfortpflanzung durch Mittelung, Differenzbildung und Messreihenbildung eliminiert und die Ausrichtungsgenauigkeit weiter erhöht werden. Mit anderen Worten können mit hinreichend schnellen Positionsmessungen Regelungssysteme für die Trajektorie der Bewegung verwendet werden, sodass Positionsfehler des Substrathalters weiter reduziert werden können.

Der, insbesondere aus einem monolithischen Block gebildete, Substrathalter der Vorrichtung zum Ausrichten weist vorzugsweise mindestens zwei der folgenden Funktionen auf:
- Substratbefestigung mit Vakuum (Vakuumbahnen, Anschlüsse), und/oder mit elektrostatischen Mitteln,
- Formkompensation zur Verformung des Substrats mittels mechanischen und/oder hydraulischen und/oder piezoelektronischen und/oder pyroelektrischen und/oder elektrothermischen Betätigungselementen,
- Positions- und/oder Lagebestimmung (Messnormalen, Reflexionsflächen und/oder Prismen, insbesondere die Reflektoren für die Interferometrie, Passmarken und/oder Passmarkenfelder, flächenhaft ausgebildete Messnormalen für Ebenen, Volumennormalen, insbesondere Stufen, Schichtsysteme bekannter Schichthöhen mit Ausrichtungsmarkierungen in Ebenen unterteilt)
- Bewegung (Führungsbahnen).

Bewegungseinrichtungen, die nicht zur Feinjustierung verwendet werden, sind insbesondere als Robotersysteme, vorzugsweise mit inkrementellen Weggebern, ausgebildet. Die Genauigkeit dieser Bewegungseinrichtungen für Hilfsbewegungen wird von der Genauigkeit zur Ausrichtung des Substratstapels entkoppelt, sodass die Hilfsbewegungen mit niedriger Wiederholungsgenauigkeit von kleiner 1 mm, bevorzugt kleiner 500 Mikrometer, besonders bevorzugt kleiner 150 Mikrometer ausgeführt werden.

Die Steuerung und/oder Regelung von der Bewegungseinrichtung der Vorrichtung zum Ausrichten zur (lateralen) Ausrichtung (Feinjustierung) wird insbesondere auf Basis von den erfassten X-Y-Z-Positionen und/oder Ausrichtungslagen durchgeführt. Dazu werden die zusätzlichen Ausrichtungsmarkierungen des Substrats mit dem in einem Sichtfeld auf der Rückseite des Substrathalters dazu ein-eindeutig zugeordneten Ausrichtungsmarken des Ausrichtungsmarkierungsfeldes korreliert. Die Höheninformation wird aus der Ausrichtungsmarkierung des Ausrichtungsmarkierungsfeldes errechnet. Dies ergibt eine X-Y-Z-Position, welche insbesondere kontinuierlich bei der Zustellbewegung der Ausrichtung und bei der Einstellung des Abstandes zum Bonden beobachtbar ist und insbesondere zur Fehlerkorrektur der Zustellbewegung in Echtzeit verwendbar ist.

Die Genauigkeit der Bewegungseinrichtungen für die Ausrichtung ist kleiner 500 nm, bevorzugt kleiner 100 nm, besonders bevorzugt kleiner 50 nm, ganz besonders bevorzugt kleiner 10 nm, bevorzugter 5 nm, am bevorzugtesten kleiner 1 nm.

In besonders bevorzugten Ausführungsformen der Vorrichtung beträgt der Fehler der Ausrichtungsgenauigkeit der Vorrichtung weniger als 20% des zulässigen höchsten Ausrichtungsfehlers, bevorzugt weniger als 10%, am bevorzugtesten weniger als 1%.

Mit anderen Worten beträgt der zulässige Ausrichtungsfehler der Substrate beispielsweise 10 nm, dann beträgt der Positionierfehler höchstens 20% des Wertes, also 2 nm.

Eine erste Ausführungsform eines beispielhaften Bondverfahrens, dass das Verfahren zum Ausrichten durchführt, umfasst folgende, insbesondere nacheinander ausgeführten und/oder gleichzeitig ausgeführten Schritte, insbesondere mit folgendem Ablauf:
Erster Verfahrensschritt: Das obere Substrat wird mit einer Auflagefläche auf den oberen Substrathalter geladen, wobei auf der gegenüberliegenden Seite, die sogenannte Kontaktseite des oberen Substrats zumindest eine erste zusätzliche Ausrichtungsmarkierung vorhanden ist.

Zweiter Verfahrensschritt: Das untere auszurichtende Substrat wird mit einer Auflagefläche auf den unteren Substrathalter geladen, wobei auf der gegenüberliegenden Seite, die sogenannte Kontaktseite des unteren Substrats zumindest eine zweite zusätzliche Ausrichtungsmarkierung vorhanden ist. Dritter Verfahrensschritt: Durch das obere Substrat hindurch wird durch eine zusätzliche Erfassungseinheit zumindest die erste zusätzliche Ausrichtungsmarkierung und gegebenen Falles eine weitere zusätzliche Ausrichtungsmarkierung des oberen Substrats erfasst.

Vierter Verfahrensschritt: Die Fokusposition eines Objektivs der zusätzlichen Erfassungseinheit wird dabei gespeichert und das Objektiv fixiert.

Fünfter Verfahrensschritt: Das obere Substrat wird mit Hilfe des oberen Substrathalters in Richtung der zusätzlichen Erfassungseinheit, aus der Fokusebene, insbesondere nach oben bewegt. Der Verfahrweg beträgt vorzugsweise weniger als 500 Mikrometer.

Sechster Verfahrensschritt: das untere Substrat wird mit Hilfe des unteren Substrathalters in die fixierte Fokusposition der zusätzlichen Erfassungseinheit, insbesondere nach oben bewegt. Insbesondere gleichzeitig kann eine Keilfehlerkompensation ebenfalls stattfinden.

Zur Erfassung der zweiten zusätzlichen Ausrichtungsmarkierung auf dem unteren Substrat wird das untere Substrat mit Hilfe des unteren Substrathalters in Z-Richtung bewegt, bis die Kontaktseite des unteren Substrats scharfgestellt wird.

Siebter Verfahrensschritt: eine zweite zusätzliche Ausrichtungsmarkierung des unteren Substrats wird durch eine zweite zusätzliche Erfassungseinheit gesucht und erfasst.

Alternativ wird das untere, durch die z-Bewegung des unteren Substrathalters scharfgestellte Substrat in der X-Y-Ebene verschoben beziehungsweise um die Z-Achse rotiert, sodass die gesuchte zweite zusätzliche Ausrichtungsmarkierung in den Fokusbereich der ersten zusätzlichen Erfassungseinheit positioniert wird und von dieser erfasst wird. Bevorzugt wird das untere Substrat weiter ausgerichtet, sodass die gesuchte Ausrichtungsmarkierung oder gesuchten Ausrichtungsmarkierungen zu den optischen Achsen der befestigten Objektive der Vorrichtung insbesondere zentrisch angeordnet werden.

In einer vorteilhaften Ausführungsform können die gesuchten Ausrichtungsmarkierungen in einem Radius kleiner 3 Millimeter, bevorzugt kleiner 2 Millimeter, besonders bevorzugt kleiner 1 Millimeter, ganz besonders bevorzugt kleiner 500 Mikrometer, noch bevorzugter kleiner 250 Mikrometer in der Umgebung der optischen Achse des jeweiligen Objektivs der Erfassungseinheiten erfasst werden.

Achter Verfahrensschritt: Durch Messsystem mit zumindest einer Erfassungseinheit zum Erfassen von Ausrichtungsmarken eines Ausrichtungsmarkierungsfeldes (insbesondere ein Messmikroskop mit Objektiv) wird eine erste Ausrichtungsmarke einer ersten Ebene und somit eine X-Y-Z-Position und/oder Ausrichtungslage des unteren Substrathalters, vorzugsweise von einer Rückseite des Substrathalters erfasst. Dabei wird der untere Substrathalter festgehalten und die Position beziehungsweise die Positionen der zusätzlichen Ausrichtungsmarkierung des unteren Substrats zu der erfassten Position korreliert. Zur Erfassung der Position des unteren Substrathalters wird das ortsfest zu dem Substrathalter angeordnete Ausrichtungsmarkierungsfeld verwendet.

Bevorzugt wird eine Stufe des Ausrichtungsmarkierungsfeldes fokussiert erfasst, welche nah zur freien Oberfläche des Ausrichtungsmarkierungsfeldes liegt und Ausrichtungsmarkierungen in der gesamten Tiefe des Ausrichtungsmarkierungsfeldes betrachtet werden können.

In dieser fokussierten Lage wird die Fokusposition (insbesondere des Objektives) der Erfassungseinheit zur Erfassung des

Ausrichtungsmarkierungsfeldes befestigt. Weiterhin wird die Erfassungseinheit örtlich fixiert beziehungsweise ortsfest gehalten.

Neunter Verfahrensschritt: das untere Substrat wird mittels des unteren Substrathalters unter Vermessung der Ausrichtungsmarken der Stufen unterschiedlicher Ebenen im Ausrichtungsmarkierungsfeld eine definierte Strecke nach unten bewegt. Die Strecke beträgt bevorzugt weniger als 500 Mikrometer. Die Strecke, mit welcher das untere Substrat abgesenkt wird, ist der sogenannte Bondgap, also der korrekte Abstand, um ein Bond, speziell ein Fusionsbond und/oder ein Hybridbond möglichst verzerrungsfrei durchführen zu können.

In einer besonders bevorzugten Ausführungsform des beispielhaften Verfahrens wird dazu das untere Substrat mit dem unteren Substrathalter so weit nach unten abgesenkt, dass im Ausrichtungsmarkierungsfeld eine Ausrichtungsmarke der nächstliegenden Stufe einer anderen Ebene scharfgestellt wird. Auf diese Weise wird eine blinde beziehungsweise gesteuerte Bewegung des Substrathalters zum Ausrichten vermieden.

Dabei wird mit der Erfassungseinheit die Bewegung des unteren Substrathalters zumindest in Anfangsposition und Zielposition erfasst, indem das Ausrichtungsmarkierungsfeld in den unterschiedlichen Stufen betrachtet wird. Dabei wird in der Anfangsposition mindestens eine Ausrichtungsmarke einer ersten Ebene erfasst und in der Zielposition mindestens eine Ausrichtungsmarke einer zweiten Ebene des Ausrichtungsmarkierungsfeldes erfasst.

Zehnter (optionaler) Verfahrensschritt: die Position des unteren Substrathalters wird mittels der gemessenen Positionsfehler zumindest in der lateralen Ebene korrigiert. Dabei wird der Substrathalter so bewegt, dass die entsprechende mindestens eine zweite Ausrichtungsmarke der zweiten Ebene scharf gestellt ist beziehungsweise im Fokusbereich der Erfassungseinheit liegt. Auf diese Weise kann durch eine Sichtkontrolle sichergestellt werden, dass der Abstand zwischen der ersten Ebene und der zweiten Ebene (also der Bondgap) ausreichend genau eingestellt wurde.

Somit kann auf die Refokussierung der Erfassungseinheit verzichtet werden und Ausrichtungsfehler vermieden werden. Durch das Ausrichtungsmarkierungsfeld wird eine Höheninformation bereitgestellt, sodass die gewünschten verfahrensrelevanten Bondabstände mit Sichtkontrolle, ohne Blindbewegung angefahren werden können. Dabei entfällt die Fokussierung und/oder Refokussierung der Erfassungseinheit, sodass der Fehler der Fokussierungsbewegung entfällt.

Elfter Verfahrensschritt: Das obere Substrat wird mit Hilfe des oberen Substrathalters erneut in die Fokusposition der zusätzlichen Erfassungseinheit beziehungsweise dessen Objektivs abgesenkt.

Zwölfter Verfahrensschritt: Mit Hilfe der korrelierten X-Y-Z-Position des unteren Substrathalters wird das obere Substrat zum unteren Substrat ausgerichtet, dabei wird das obere Substrat bevorzugt in der X-Y-Ebene bewegt und/oder um die Z-Achse rotiert.

In diesem Verfahrensschritt werden die ersten zusätzlichen Ausrichtungsmarkierungen zu den zweiten zusätzlichen Ausrichtungsmarkierungen ausgerichtet. Die tatsächliche Position des unteren Substrats auf dem unteren Substrathalter ist bekannt, weil die korrelierten Positionen der Ausrichtungsmarkierungen des unteren Substrats zum Ausrichtungsmarkierungsfeld vermessen wurden, sodass hierdurch die Ausrichtungsmarkierungen des oberen Substrats zu den bekannten, verdeckt liegenden Position der zweiten Ausrichtungsmarkierungen des unteren Substrats ausgerichtet werden können.

Dreizehnter Verfahrensschritt: Das untere Substrat wird zur Einstellung des korrekten Bondabstands angehoben, dabei können abweichende Bewegungen mit Hilfe des Ausrichtungsmarkierungsfeldes beobachtet und korrigiert werden.

Vierzehnter Verfahrensschritt: die Kontaktflächen des oberen und des unteren Substrats werden kontaktiert, die Substrate werden zueinander gebondet.

Bei der Ausrichtung der Substrate zueinander können Korrekturen an deren relativen Position zueinander durchgeführt werden, falls der Ausrichtungsfehler einen festgelegten Grenzwert überschreitet.

Die Ausrichtungsfehler, bei welchen Korrekturen angewendet werden sind für Verschiebungen kleiner 500 Mikrometer, bevorzugt kleiner 100 Mikrometer, besonders bevorzugt kleiner 100 Nanometer, ganz besonders bevorzugt kleiner 10 Nanometer, noch bevorzugter kleiner 5 Nanometer, am bevorzugtesten kleiner als 1 Nanometer.

Die Ausrichtungsfehler, bei welchen Korrekturen für Verdrehungen angewendet werden, sind kleiner 50 Mikroradiant, bevorzugt kleiner 10 Mikroradiant, besonders bevorzugt kleiner 5 Mikroradiant, ganz besonders bevorzugt kleiner 1 Mikroradiant, noch bevorzugter kleiner 0,1 Mikroradiant, am bevorzugtesten kleiner als 0,05 Mikroradiant.

In einer weiteren Ausführungsform des Verfahrens zum Ausrichten wird durch Parallelisierung der Verfahrensschritte eine Beschleunigung erreicht, insbesondere wird während eines Mustererkennungsschrittes am ersten Substrat bereits die Beladung des zweiten Substrates durchgeführt.

Die Begriffe, dass Achsen zusammenfallen oder Deckungsgleichheit oder Parallelität oder Normalität werden in dieser Offenbarung als Begriffe toleranzbehafteter Größen verwendet, sodass insbesondere die Toleranzen nicht tolerierten Längen- bzw. Winkelmasse gemäß ISO 2768 gelten, es sei denn die Toleranzen sind explizit angegeben.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen schematisch in:
- Figur 1: eine Querschnittsdarstellung einer Ausführungsform einer erfindungsgemäßen Vorrichtung,
- Figur 2a: eine Draufsichtdarstellung eines beispielhaften Ausrichtungsmarkierungsfeldes mit Ausrichtungsmarken,
- Figur 2b: eine Schnittdarstellung einer Ausführungsform eines Ausrichtungsmarkierungsfeldes,
- Figur 3: eine Draufsichtdarstellung einer Ausführungsform eines Ausrichtungsmarkierungsfeldes mit Ausrichtungsmarken
- Figur 4: eine Schnittdarstellung einer Ausführungsform eines Ausrichtungsmarkierungsfeldes mit einer Erfassungseinheit.

In den Figuren sind Vorteile und Merkmale der Erfindung mit diese jeweils identifizierenden Bezugszeichen gemäß Ausführungsformen der Erfindung gekennzeichnet, wobei Bauteile beziehungsweise Merkmale mit gleicher oder gleichwirkender Funktion mit identischen Bezugszeichen gekennzeichnet sind.

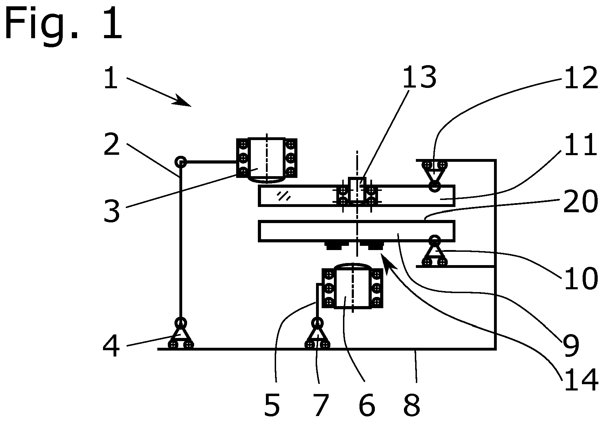

In Fig. 1 ist eine schematische, nicht maßstabgetreue Funktionaldarstellung, der Hauptkomponenten einer Ausführungsform einer Ausrichtungsanlage 1 abgebildet. Die Ausrichtungsanlage 1 ist in der Lage, in der Figur 1 nicht eingezeichnete Substrate zueinander auszurichten und miteinander zumindest teilweise und/oder vorläufig (sogenannter Pre-Bond) zu verbinden. Die Begriffe Vorrichtung und Anlage werden gleichwertig und gleichbedeutend verwendet.

Die Ausrichtungsanlage 1 beinhaltet einen ersten Substrathalter 9, auf welchem ein erstes Substrat auf einer Substrathalteroberfläche geladen werden kann und fixierbar ist. Weiterhin beinhaltet die Ausrichtungsanlage 1 einen zweiten Substrathalter 11, auf welchem ein zweites Substrat geladen werden kann und fixierbar ist.

Der erste, insbesondere auszurichtende untere, Substrathalter 9 ist an einer ersten Bewegungseinrichtung 10 zur Halterung und Umsetzung von Zuführsowie Justierbewegungen (Ausrichtung) des ersten Substrathalters 9 angeordnet. Der zweite, insbesondere obere, Substrathalter 11 ist an einer zweiten Bewegungseinrichtung 12 zur Halterung und Umsetzung von Zuführsowie Justierbewegungen (Ausrichtung) des zweiten Substrathalters 11 angeordnet. Die Bewegungseinrichtungen 10, 12 sind insbesondere an einem gemeinsamen, massiven Tisch oder Gestell 8 fixiert, um Schwingungen aller funktionalen Bauteile zu reduzieren/minimieren. Das Gestell kann insbesondere eine aktive Schwingungsdämpfung beinhalten.

Zur Beobachtung (Erfassung) von zusätzlichen Ausrichtungsmarkierungen auf den Substraten beinhaltet ein optisches System 2 der Ausrichtungsanlage 1 zumindest eine zusätzliche Erfassungseinheit 3, insbesondere ein Bilderfassungsmittel, zur Erfassung von den zusätzlichen Ausrichtungsmarkierungen.

Das optische System 2 ist auf eine Fokusebene beziehungsweise Fokusposition fokussierbar, die zwischen dem ersten und zweiten Substrat, bevorzugt zwischen den Substrathaltern 9 und 11 verortet wird, wenn diese zur Ausrichtung angeordnet sind. Bewegungen des optischen Systems 2, insbesondere in X-, Y- und Z-Richtung, werden mittels einer Positioniervorrichtung 4 zur Positionierung des optischen Systems 2 durchgeführt. Die Positioniervorrichtung 4 kann insbesondere an dem massiven Tisch oder Gestell fixiert werden.

Mindestens ein zusätzliches, insbesondere optisches, Messsystem 5 mit mindestens Erfassungseinheit 6 zur Erfassung eines Ausrichtungsmarkierungsfeldes 14 wird für die Erhöhung der Ausrichtungsgenauigkeit durch Erfassung von Ausrichtungsmarken unterschiedlicher Ebenen des Ausrichtungsmarkierungsfeldes 14 verwendet. Eine Bewegung des zusätzlichen Messsystems wird mit einer Positioniereinrichtung 7 ausgeführt.

Soweit es sich um ein optisches Messsystem 5 handelt, kann die Positioniereinrichtung 7 eine Fokussierung in Bezug auf eine Ausrichtungsmarke einer ersten Ebene 18 des Ausrichtungsmarkierungsfeldes 14 durch Bewegung der Erfassungseinheit 6 in Z-Richtung vornehmen. Eine Positionierung in X-Y-Richtung ist ebenfalls denkbar, wobei während der Ausrichtung insbesondere eine Fixierung, vorzugsweise an dem Tisch/Gestell, erfolgt.

In der dargestellten Ausführungsform der Ausrichtungsanlage 1 wird mit dem Messsystem 5 beziehungsweise der Erfassungseinheit 6 insbesondere die X- Y-Position und/oder Lage (insbesondere auch die Rotationslage) und/oder die Höhenposition des unteren Substrathalters 9 mit besonders hoher Genauigkeit erfasst.

Zur Einleitung eines Fusionsbondes kann zumindest das obere Substrat mit einer Substratvorspannunsvorrichtung 13 vorgespannt werden. Die Vorspannung kann mittels mechanischer Vorspannung mit einem Vorspannelement, ein sogenannter Bondpin, erfolgen. In einer weiteren Ausführungsform der Substratvorspannungsvorrichtung kann die Vorspannung des Substrats mit einem Fluid, insbesondere mit einem Gas aus einer Düse, insbesondere aus einer beweglichen Düse erfolgen.

Mit nicht dargestellten, jedoch bevorzugten Ausführungsformen der Vorrichtung können folgende, beispielhaft aufgeführte Verfahrensschritte durchgeführt werden:
Auf einer ersten Fixierfläche, insbesondere Substrathalteroberfläche, des ersten Substrathalters 9 wird das erste/untere Substrat befestigt. Als Befestigung wird insbesondere eine mechanische und/oder elektrostatische Klemmung, Anpresskraft, welche wegen einer Druckdifferenz zwischen Umgebung in Normalatmosphäre und Unterdruck am ersten Substrathalter 9 erzeugt wird, auch als Vakuumfixierung genannt, verwendet. Die Befestigung erfolgt insbesondere so, dass das erste Substrat während des gesamten Verfahrens relativ zum ersten Substrathalter 9 keine ungenaue oder unerwünschte Bewegung erfährt. Es kann insbesondere eine thermische Wärmedehnung unterbunden oder reduziert werden, soweit der erste Substrathalter 9 und das erste Substrat jeweils einen korrespondierenden, vorzugsweise linear korrespondierend verlaufenden, Wärmedehnungskoeffizienten besitzen, wobei der Unterschied der Wärmedehnungskoeffizienten und/oder des linearen Verlaufs der Wärmedehnungskoeffizienten vorzugsweise weniger als 5%, bevorzugt weniger 3%, besonders bevorzugt weniger 1%, beträgt.

Bevorzugt wird die Anlage in einer temperaturstabilisierten Umgebung, insbesondere in einem Reinraum, betrieben in welcher eine Temperaturschwankung kleiner als 0,5 Kelvin, bevorzugt kleiner als 0,1 Kelvin, besonders bevorzugt kleiner als 0,05 Kelvin, am bevorzugtesten kleiner als 0,01 Kelvin während eines Ausrichtungszyklus ist.

Das fixierte erste Substrat und der erste Substrathalter 9 können als quasimonolithischer Körper für die Ausführung der Bewegungen des ersten Substrats verstanden werden, welche keine Relativbewegungen zueinander erlauben.

Diese Substratbefestigung kann formschlüssig und/oder bevorzugt kraftschlüssig erfolgen. Durch die quasi-monolithische Verbindung führt dazu, dass die Einflüsse, welche zwischen dem Substrathalter und Substrat eine Verschiebung und/oder Verdrehung und/oder Deformation bewirken können, mindestens reduziert, bevorzugt mindestens eine Größenordnung reduziert, besonders bevorzugt eliminiert werden.

Mit Formschluss oder Kraftschluss kann das Substrat mit dem Substrathalter so verbunden werden, dass insbesondere die Differenz einer thermischen Dehnung unterdrückt werden kann. Weiterhin kann mit dem Substrathalter die eigenständige Deformation des Substrates reduziert, eliminiert und/oder korrigiert werden.

In einer Ausführungsform können sowohl der untere Substrathalter 9 als auch der obere Substrathalter 11 zusätzliche, passiv und/oder aktiv betriebene Verformungselemente und/oder Zwischenplatten beinhalten, um die mechanischen und/oder thermischen Eigenschaften der Substrate für die Reduzierung des Restfehlers der Ausrichtung nach dem Fügen zu minimieren.

Der erste Substrathalter 9 kann sich während der Erfassung einer ersten zusätzlichen Ausrichtungsmarkierung in einem optischen Pfad der zusätzlichen Erfassungseinheit 3 befinden. Die erste zusätzliche Ausrichtungsmarkierung kann auf der zu bondenden Kontaktfläche des ersten Substrats im Blickfeld, insbesondere im optischen Pfad, bevorzugt in der optischen Achse der zusätzliche Erfassungseinheit 3, angeordnet werden. Die zusätzliche Erfassungseinheit 3 erzeugt ein, insbesondere digitales, Bild, welches vermessen wird. Eine erste Ausrichtungsmarkierung eines Substrats kann auch aus mehreren, zusammengesetzten Ausrichtungsmarkierungen bestehen. Aus dem Bild der Ausrichtungsmarkierung wird ein Messwert erzeugt/berechnet, welcher insbesondere die X-Y-Position und/oder Ausrichtungslage (insbesondere in Rotationsrichtung um eine Z-Richtung), also den Ausrichtungszustand eines ersten Substrates charakterisiert.

Der untere Substrathalter 9 und/oder das erste Substrat weisen die Ausrichtungsmarken des Ausrichtungsmarkierungsfeldes 14 auf, anhand der die X-Y-Z-Position und/oder Ausrichtungslage, insbesondere der räumliche Ausrichtungszustand des Substrathalters 9 und/oder des ersten Substrats insbesondere aus einer anderen Richtung, vorzugsweise einer diametral zur ersten Erfassung in Z-Richtung gegenüberliegenden Richtung, erfasst werden.

Vorzugsweise ist eine Relativbewegung der ersten Erfassungseinheit 3 zur dritten Erfassungseinheit 6 messbar. Noch bevorzugter wird von der Erfassung der ersten zusätzlichen Ausrichtungsmarkierung und einer Ausrichtungsmarke des Ausrichtungsmarkierungsfeldes 14 bis zur Kontaktierung des ersten und zweiten Substrates keine Relativbewegung zwischen der ersten zusätzlichen Erfassungseinheit 3 und der Erfassungseinheit 6 ausgeführt.

Die Erfassungseinheit 6 zur Erfassung des Ausrichtungsmarkierungsfeldes 14 des zusätzlichen Messsystems 5 liefert aus der Vermessung der Ausrichtungsmarken unterschiedlicher Ebenen des Ausrichtungsmarkierungsfeldes 14 einen Messwert der räumlichen X-Y-Z-Position und/oder Lage des ersten/unteren Substrathalters 9.

Die Messwerte (X-Y-Position und/oder Ausrichtungslage des ersten Substrats sowie X-Y-Z-Position und/oder Ausrichtungslage des ersten Substrathalters 9 oder des ersten Substrats 16) werden miteinander korreliert, so dass die X-Y-Z-Position des Substrathalters 9 reproduzierbar wiederherstellbar ist. Damit kann das auf dem Substrathalter 9 befestigte Substrat zur Ausrichtung sowie zur Einstellung des Bondabstands geregelt bewegt werden, ohne dass die zusätzlichen Ausrichtungsmarkierungen des Substrats direkt beobachtbar sind.

Durch die Zuordnung der Position des Substrats zur räumlichen Position und/oder Lage des Substrathalters 9 wird eine Ausrichtung ohne direkte Beobachtung der X-Y-Positionen und/oder Ausrichtungslagen des jeweiligen Substrats während der Ausrichtung und/oder Kontaktierung realisierbar. Weiterhin kann der Abstand zwischen den Substraten während der Ausrichtung definiert eingestellt und/oder minimiert werden. Der Abstand kann vorzugsweise bereits dem Abstand der Substrate während der Erfassung der ersten und zweiten zusätzlichen Ausrichtungsmarkierungen entsprechen. In anderen Ausführungsformen kann der bevorzugte Abstand zum Bonden eingestellt werden.

Mit anderen Worten wird insbesondere ein hindernisfreier optischer Pfad zwischen dem Substrathalter 9 und des zusätzlichen Messsystem 5 bereitgestellt, mit welchem die Ausrichtung der Substrate in einem Regelkreis betrieben werden kann oder betrieben wird. So kann die X-Y-Z-Position und/oder Ausrichtungslage des ersten Substrathalters 9 und somit des auf dem ersten Substrathalter 9 fixierten ersten Substrates genau bestimmt und reproduzierbar wiederhergestellt werden, was wiederum die Genauigkeit beim Bonden, insbesondere Fusionsbonden erhöhen.

Die Wiederherstellung und die korrekte Einstellung der X-Y-Z-Position und/oder Ausrichtungslage insbesondere des Substrathalters 9 und insbesondere damit monolithisch verbundenen Substrats zum anderen Substrat und/oder Substrathalter ist ein wichtiger Aspekt der Vorrichtung zum Ausrichten.

Insbesondere wird eine Wiederholungsgenauigkeit der Positionierung (gemessen als relativer Ausrichtungsfehler zwischen den zwei Substraten), auch als Umkehrspiel bekannt, von unter 500 nm, bevorzugt unter 100 nm, besonders bevorzugt unter 30 nm, ganz besonders bevorzugt unter 10 nm, noch bevorzugter unter 5 nm, am bevorzugtesten unter 1 nm erreicht. Das Umkehrspiel kann auch das wiederholte Anfahren einer gegebenen Position mit Hilfe der Bewegungseinrichtungen 10, 12 und/oder 4, 7 sein. Das Umkehrspiel resultiert aus den Bewegungen der Bewegungseinrichtungen, lediglich der Erfassungsort variiert, sodass die Messgröße als relativer Ausrichtungsfehler existiert.

Es ist zur weiteren Erhöhung der Ausrichtungsgenauigkeit bevorzugt, die erste zusätzliche Erfassungseinheit 3 mit der zweiten zusätzlichen Erfassungseinheit 5 zeitsynchronisiert zu betreiben, insbesondere mit einem Zeitunterschied der Erfassungen der Messwerte von unter 3 Sekunden, bevorzugt unter 1 Sekunde, besonders bevorzugt unter 500 Millisekunden, ganz besonders bevorzugt unter 100 Millisekunden, noch bevorzugter Fall unter 10 Millisekunden, am bevorzugtesten unter 1 Millisekunden, im idealen Fall gleichzeitig. Dies ist besonders vorteilhaft, weil die Wirkung von Störeinflüssen wie mechanische Schwingungen eliminiert werden kann. Mechanische Schwingungen breiten sich unter anderem mit Körperschall mit einigen Tausend m/s in den Werkstoffen aus. Falls eine Regelung und die Erfassungsmittel schneller arbeiten, als die Ausbreitungsgeschwindigkeit des Körperschalls, wird eine Störung reduziert oder eliminiert.

Ändert eine Störung die Lage des ersten Substrats auf dem ersten Substrathalter 9 so, dass die erste zusätzliche Erfassungseinheit 3 bereits einen Messwert aufgenommen hat und das Messsystem 5 mit der Erfassungseinheit 6 zur Erfassung des Ausrichtungsmarkierungsfeldes 14 noch keinen Messwert aufgenommen hat, kann die Störung einen Anteil an der Verminderung der Genauigkeit der Ausrichtung bewirken, da in der Zeit zwischen den Messwertaufnahmen der zusätzlichen Erfassungseinheit 3 und der Erfassungseinheit 6 insbesondere schwingungsbedingte, schnelle mechanische Positionsänderungen in einer Nanometer- oder Mikrometer-Größenordnung erfolgen können. Erfolgt die Messwertaufnahme zeitverzögert (in der Größenordnung von Sekunden oder Minuten) können weitere Störeinflüsse wie thermisch bedingte Formänderungen oder Längenänderungen ebenfalls die Ausrichtungsgenauigkeit herabsetzen.

Werden die erste zusätzliche Erfassungseinheit 3 und die Erfassungseinheit 6 zur Erfassung des Ausrichtungsmarkierungsfeldes 14 zueinander synchronisiert (insbesondere durch zeitgleiche Auslösung der Erfassung sowie Ausgleich der Erfassungszeit und/oder gleiche Integrationszeit für Kamerasysteme), können einige Störeinflüsse reduziert, im optimalen Fall eliminiert werden, da die Erfassung zu einem Zeitpunkt erfolgen soll, in dem die Störeinflüsse möglichst minimale Auswirkung auf die Erfassungsgenauigkeit haben.

In einer bevorzugten Ausführungsform des Verfahrens und der Vorrichtung zum Ausrichten wird bei bekannten, insbesondere periodischen Störeinflüssen, insbesondere im Scheitelpunkt der Schwingung, synchronisiert die Erfassung erfolgen. Mit Vorzug können dazu im Vorfeld Schwingungssensoren (Beschleunigungssensoren, Interferometer, Vibrometer) an für die Genauigkeit relevanten Stellen der Vorrichtung zum Ausrichten angebracht werden. Die Störeinflüsse werden von diesen Schwingungssensoren aufgenommen und zur Eliminierung, insbesondere durch Recheneinheiten, durch Berechnung berücksichtigt beziehungsweise bereinigt. In einer weiteren Ausführungsform können die Schwingungssensoren an den charakteristischen Stellen der Anlage fest verbaut werden.

Für die Ausrichtung der Substrate wird insbesondere ein ermittelter/festgelegter Sollwert verwendet. Der Sollwert beinhaltet insbesondere Bilddaten der Ausrichtungsmarken des Ausrichtungsmarkierungsfeldes 14 des ersten Substrathalters 9 und/oder die ermittelten X-Y-Z-Positions- und/oder Ausrichtungslagedaten für die Bewegungseinrichtung 10 des ersten Substrathalters 9 und/oder Regelungsparameter wie Bahnkurven zum optimalen Anfahren der räumlichen Position und/oder insbesondere maschinenlesbare Werte für die Antriebe.

Mittels der ersten Bewegungseinrichtung 10 wird der erste Substrathalter 9 in positions- und insbesondere lagegeregelter Form so lange bewegt, bis der Ausrichtungsfehler, welcher aus dem Sollwert der Erfassungseinheit und der aktuellen Position und/oder Lage des Substrathalters berechnet wird, minimiert, im Idealfall eliminiert ist beziehungsweise ein Abbruchkriterium erreicht wird. Diese Bewegung des unteren Substrathalters beinhaltet ebenfalls den korrekt eingestellten Abstand zum Bonden, insbesondere zum Fusionsbonden. Mit anderen Worten wird der untere Substrathalter 9 in kontrollierter, geregelter Weise auf die bereits bekannte, vermessene X-Y-Z-Ausrichtungsposition gefahren und geregelt insbesondere in Z-Richtung bewegt.

In weiteren Ausführungsformen können Restfehler, die bei der Positionierung des oberen und/oder unteren Substrates nicht eliminiert werden konnten hier ebenfalls als Korrekturwerte für die Positionierung des anderen (unteren bzw. oberen) Substrates berücksichtigt werden.

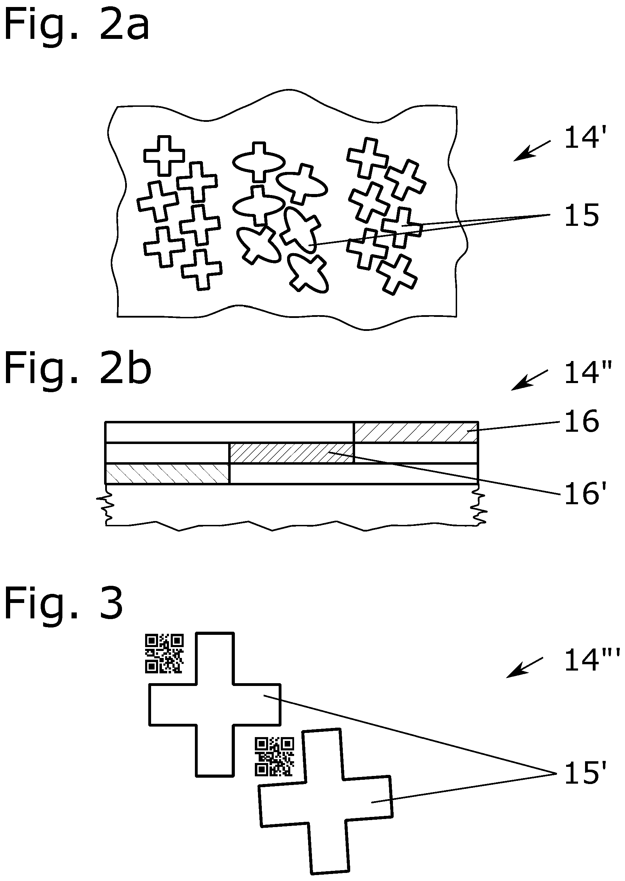

Figur 2a zeigt ein Ausrichtungsmarkierungsfeld 14' in schematischer, stark vergrößerter Draufsicht mit exemplarische ausgewählten Ausrichtungsmarken 15 beziehungsweise Ausrichtungsmarkierungen 15.

Die einzelnen Ausrichtungsmarken 15 stellen symbolisch und schematisch eine absolute, eindeutige Kodierung der Position und der Lage jeder einzelnen Ausrichtungsmarke beziehungsweise Ausrichtungsmarkierung 15 dar. Die einzelnen Ausrichtungsmarken 15 bzw. Ausrichtungsmarkierungen 15 können in unterschiedlichen Ebenen des Ausrichtungsmarkierungsfeldes 14' vorliegen. Da die Beschaffenheit (x-y-z-Position eines jeder Ausrichtungsmarkierung 15) des Ausrichtungsmarkierungsfeldes 14' a-priori bekannt ist, reicht für die absolute Positionserfassung des nicht dargestellten Substrathalters, dass eine absolut kodierte Ausrichtungsmarke 15 bzw. Ausrichtungsmarkierung 15 erfasst wird.

Figur 2b zeigt ein Ausrichtungsmarkierungsfeld 14" mit unterschiedlichen, exemplarisch markierten Schichten 16, 16' des Ausrichtungsmarkierungsfeldes 14" in einer schematischen Schnittdarstellung.

Es ist vorteilhaft, wenn bei der Ausrichtung des Substrathalters, welcher das Ausrichtungsmarkierungsfeld beinhaltet beziehungsweise ortsfest zu diesem angeordnet ist, mehrere Ausrichtungsmarken unterschiedlicher Ebenen berücksichtigt werden. Dabei können insbesondere mehrere Stufen und/oder Schichten 16, 16' des Ausrichtungsmarkierungsfeldes gleichzeitig oder bevorzugt nacheinander im Blickfeld beziehungsweise Fokusbereich der Erfassungseinheit 6 liegen und somit erfasst werden. Durch die bekannten Stufenhöhen beziehungsweise den bekannten Abständen zwischen den Ebenen können diese zur Ausrichtung beziehungsweise zur Einstellung des gewünschten Abstandes zwischen den Substraten verwendet werden.

Der Abstand zwischen den Ebenen beträgt zwischen 1 Mikrometer und 300 Mikrometer, bevorzugt zwischen 5 Mikrometer und 200 Mikrometer, besonders bevorzugt zwischen 10 Mikrometer und 100 Mikrometer, im optimalen Fall zwischen 25 Mikrometer und 75 Mikrometer, im idealen Fall zwischen 48 Mikrometer und 52 Mikrometer. In speziellen Fällen beträgt der Abstand zwischen den Ebenen 50,00 Mikrometer.

Es ist vorteilhaft, wenn die Ausrichtungsmarken 15, 15' eines Ausrichtungsmarkierungsfeldes 14, 14', 14", 14‴ die räumliche Position und/oder Lage des Substrathalters 9 beziehungsweise des auf dem Substrathalter angeordneten Substrates bereitstellt. Zudem ist es vorteilhaft, wenn die jeweiligen Ausrichtungsmarken 15, 15' eine erfassbare Lageinformation aufweisen, welche die jeweilige Lage innerhalb des Ausrichtungsmarkierungsfeldes 14, 14', 14", 14‴ bereitstellt. Somit ist insbesondere auch die Lage der jeweiligen erfassten Ausrichtungsmarke 15, 15' zu den Ausrichtungsmarken 15 des Ausrichtungsmarkierungsfeldes bekannt. Vorzugsweise ist nicht nur die Lage der erfassten Ausrichtungsmarke 15, 15' zu den Ausrichtungsmarken 15, 15' der gleichen Ebene bekannt, sondern auch die Lage der jeweiligen Ebene der erfassten Ausrichtungsmarke 15, 15' zu den anderen Ebenen des Ausrichtungsmarkierungsfeldes. Dies jeweilige Lageinformation wird beispielsweise mit unterschiedlichen Winkeln sowie unterschiedlichen Formen der Ausrichtungsmarkierungen 15, 15' ermöglicht und exemplarisch schematisch dargestellt.

Für die genaue Einstellung eines gewünschten Abstandes beziehungsweise eines Bondabstandes zwischen den Substraten soll bevorzugt das optische System einer Erfassungseinheit 6 zur Erfassung des Ausrichtungsmarkierungsfeldes 14, 14', 14", 14‴ eine geringere Schärfentiefe beziehungsweise eine geringere Tiefe des Fokusbereichs (insbesondere in Z-Richtung) aufweisen, als der halbe Abstand zwischen der entsprechenden Ebenen beträgt.

Figur 3 zeigt eine mögliche Ausführungsform eines Ausrichtungsmarkierungsfeldes 14", wobei die einzelnen exemplarischen Ausrichtungsmarken 15' mit maschinenlesbarem Code ergänzt sind. Dabei können die einzelnen Ausrichtungsmarken 15 auf unterschiedlichen Ebenen (Stufen und/oder Schichten) angeordnet sein und eine Angabe, um welche Ebene es sich jeweils handelt, in dem Code enthalten sein. Weiterhin kann eine eindeutige Angabe der Position und Lage der jeweiligen Ausrichtungsmarke 15' in dem Code enthalten sein.

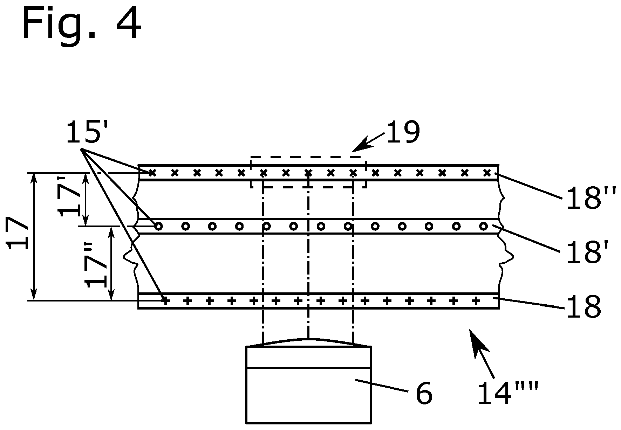

In Figur 4 ist eine Ausführungsform eines Ausrichtungsmarkierungsfeldes 14ʺʺ in einer Schnittansicht dargestellt. Die Ausrichtungsmarken 15' des Ausrichtungsmarkierungsfeldes 14ʺʺ sind in drei unterschiedlichen Ebenen 18, 18', 18" angeordnet und durch die Erfassungseinheit 6 erfassbar. Dabei kann die Erfassungseinheit 6 lediglich die Ausrichtungsmarken 15' innerhalb des Fokusbereiches 19 erfassen.

Eine erste Ebene 18 weist dabei zu einer zweiten Ebene 18' einen bekannten Abstand 17" auf. Die zweite Ebene 18' weist zu einer dritten Ebene 18" den ebenfalls bekannten Abstand 17' auf. Zudem ist der Abstand 17 zwischen der ersten Ebene 18 und der dritten Ebene 18" bekannt. Der Abstand 17" und der Abstand 17' sind in der dargestellten Ausführungsform unterschiedlich groß, so dass bei der Verwendung des Ausrichtungsmarkierungsfeldes 14ʺʺ zum Ausrichten eines Substrates jeweils alle drei Abstände 17, 17' und 17" anfahrbar beziehungsweise einstellbar sind.

Kombinationen der Abstände 17, 17', 17'' können durch mehrfaches Bewegen des zu dem Ausrichtungsmarkierungsfeld 14ʺʺ ortsfesten Substrathalters (9) auch angefahren werden. Beispielsweise kann zunächst der Abstand 17'' eingestellt werden und im Anschluss der in derselben Richtung der Abstand 17' dazu angefahren werden. Auch kann zum Beispiel der Substrathalter um den doppelte Abstand 17'' bewegt werden. Dazu wird in zwei Schritten ausgerichtet und die Erfassungseinheit entsprechend zwischen den Schritten eingestellt, da eine Fokusposition und damit der Fokusbereich 19 der Erfassungseinheit 6 angepasst wird.

### Bezugszeichenliste

- 1: Vorrichtung zum Ausrichten, Ausrichtungsanlage
- 2: optisches System
- 3: zusätzliche Erfassungseinheit
- 4: Positioniervorrichtung
- 5: zusätzliches Messsystem
- 6: Erfassungseinheit (Ausrichtungsmarkierungsfeld)
- 7: Positioniervorrichtung des zusätzlichen Messsystems
- 8: Gestell
- 9: Substrathalter, erster (auszurichtender) Substrathalter
- 10: Bewegungseinrichtung des auszurichtenden Substrathalters, Erste Bewegungseinrichtung
- 11: zweiter/oberer Substrathalter
- 12: Zweite Bewegungseinrichtung
- 13: Substratverformungsvorrichtung
- 14, 14', 14", 14‴: Ausrichtungsmarkierungsfeld
- 15, 15': Ausrichtungsmarken, Ausrichtungsmarkierung
- 16, 16': Schichten einer Ausrichtungsmarkierung eines Ausrichtungsmarkierungsfeldes
- 17, 17', 17": Abstand
- 18, 18',18": Ebenen des Ausrichtungsmarkierungsfeldes
- 19: Fokusbereich der Erfassungseinheit in einer Fokusposition
- 20: Substrathalteroberfläche des (auszurichtenden) Substrathalters

## Patentansprüche

1. Verfahren zum Ausrichten eines Substrates mit zumindest den folgenden Schritten:
i) Bereitstellung eines Substrathalters (9) mit einer zur Aufnahme des Substrates ausgebildeten Substrathalteroberfläche (20) und eines zu dem Substrathalter (9) ortsfest angeordneten Ausrichtungsmarkierungsfeldes (14, 14', 14", 14‴),
ii) Ausrichten des Substrates,
**dadurch gekennzeichnet, dass** das Substrat anhand von übereinander angeordneten Ausrichtungsmarken (15, 15') des Ausrichtungsmarkierungsfeldes (14, 14', 14", 14‴) ausgerichtet wird, wobei das Ausrichten des Substrates in Schritt ii) die folgenden Schritte aufweist, insbesondere mit dem folgenden Ablauf:
a) Erfassung einer ersten Ausrichtungsmarke (15, 15') einer ersten Ebene (18, 18',18") des Ausrichtungsmarkierungsfeldes (14, 14', 14", 14‴) durch eine Erfassungseinheit (6),
b) Fixierung einer Fokusposition der Erfassungseinheit (6) nach der Erfassung in Schritt a),
c) Bewegung des Substrathalters (9) senkrecht zu der ersten Ebene (18, 18',18") des Ausrichtungsmarkierungsfeldes (14, 14', 14", 14"'),
d) Erfassung einer zweiten Ausrichtungsmarke einer zweiten Ebene (18, 18',18") des Ausrichtungsmarkierungsfeldes (14, 14', 14", 14‴) durch die Erfassungseinheit (6),
wobei die erste Ebene (18, 18',18") und die zweite Ebene (18, 18',18") zueinander parallel angeordnet sind, und wobei die erste Ebene (18, 18',18") und die zweite Ebene (18, 18',18") einen Abstand (17, 17', 17") zueinander aufweisen.

2. Verfahren nach Anspruch 1, wobei in Schritt a) zusätzliche Ausrichtungsmarken an dem Substrathalter (9) oder auf dem Substrat von mindestens einer zusätzlichen Erfassungseinheit (3) erfasst werden.

3. Verfahren nach wenigstens einem der vorhergehenden Ansprüche, wobei während der Bewegung des Substrathalters (9) in Schritt iv) die Erfassungseinheit (6) in der Fokusposition kontinuierlich das Ausrichtungsmarkierungsfeld (14, 14', 14", 14‴) vermisst.

4. Verfahren nach wenigstens einem der vorhergehenden Ansprüche, wobei nach der Fixierung der Fokusposition in Schritt b) die Erfassungseinheit (6) ortsfest gehalten wird.

5. Verfahren nach wenigstens einem der vorhergehenden Ansprüche, wobei bei dem Erfassen der ersten Ausrichtungsmarke (15, 15') in Schritt a) und/oder bei dem Erfassen der zweiten Ausrichtungsmarke (15, 15') in Schritt d) von der Erfassungseinheit (6) zusätzlich eine Information über die Lage der jeweiligen Ausrichtungsmarke (15, 15') innerhalb des Ausrichtungsmarkierungsfeldes (14, 14', 14", 14‴) bereitgestellt wird.

6. Vorrichtung zum Ausrichten eines Substrates, zumindest aufweisend:
A) einen Substrathalter (9) mit einer zur Aufnahme des Substrates ausgebildeten Substrathalteroberfläche (20), und
B) ein zu dem Substrathalter (9) und zu dem Substrat ortsfest angeordnetes Ausrichtungsmarkierungsfeld (14, 14', 14", 14"') mit Ausrichtungsmarken (15, 15'),
**dadurch gekennzeichnet, dass** das Substrat anhand von übereinander angeordneten Ausrichtungsmarken (15, 15') ausrichtbar ist,
die Vorrichtung ferner aufweisend:
C) eine Erfassungseinheit (9) zur Erfassung der Ausrichtungsmarken (15, 15') des Ausrichtungsmarkierungsfeldes (14, 14', 14", 14‴) und
D) eine Bewegungseinrichtung (10) zum Bewegen des Substrathalters (9),
- wobei die Ausrichtungsmarken (15, 15') des Ausrichtungsmarkierungsfeldes (14, 14', 14", 14‴) in einer ersten Ebene (18, 18',18") und einer zweiten Ebene (18, 18',18") angeordnet sind, und wobei die erste Ebene (18, 18',18") und die zweiten Ebene (18, 18',18") parallel zueinander angeordnet sind, und wobei die erste Ebene (18, 18',18") und die zweite Ebene (18, 18',18") einen Abstand (17, 17', 17") zueinander aufweisen, und
- wobei eine erste Ausrichtungsmarke (15, 15') der Ausrichtungsmarken (15, 15') der ersten Ebene (18, 18',18") in einer Fokusposition der Erfassungseinheit (6) erfassbar ist, und wobei die Fokusposition der Erfassungseinheit (6) fixierbar ist, und
- wobei in der Fokusposition durch die Erfassungseinheit (6) eine zweite Ausrichtungsmarke (15, 15') der Ausrichtungsmarken (15, 15') der zweiten Ebene (18, 18',18") erfassbar ist,
und wobei der Substrathalter (9) senkrecht zu der ersten Ebene (15, 15') durch die Bewegungseinrichtung (10) bewegbar ist.

7. Vorrichtung nach wenigstens einem der vorhergehenden Ansprüche, wobei die Ausrichtungsmarken (15, 15') der ersten Ebene (18, 18',18") und die Ausrichtungsmarken (15, 15') der zweiten Ebene (18, 18',18") in dem Ausrichtungsmarkierungsfeld (14, 14', 14", 14‴) fluchtend übereinander, insbesondere deckungsgleich, angeordnet sind.

8. Vorrichtung nach Anspruch 6, wobei die Ausrichtungsmarken (15, 15') der ersten Ebene (18, 18',18") zu den Ausrichtungsmarken (15, 15') der zweiten Ebene (18, 18',18") stufenartig versetzt angeordnet sind.

9. Vorrichtung nach wenigstens einem der vorhergehenden Ansprüche, wobei das Ausrichtungsmarkierungsfeld (14, 14', 14", 14‴) auf einer der Substrathalteroberfläche (20) abgewandten Rückseite des Substrathalters (9) angeordnet ist.

10. Vorrichtung nach Anspruch 6, wobei ein Mittelpunkt des Ausrichtungsmarkierungsfeldes (14, 14', 14", 14‴) auf der Rückseite des Substrathalters (9) zumindest teilweise mit einem Mittelpunkt der Substrathalteroberfläche (20) fluchtet.

11. Vorrichtung nach wenigstens einem der vorhergehenden Ansprüche, wobei das Ausrichtungsmarkierungsfeld (14, 14', 14", 14‴) auf einer der Substrathalteroberfläche (20) zugewandten Seite des Substrates angeordnet ist.

12. Vorrichtung nach wenigstens einem der vorhergehenden Ansprüche, wobei das Ausrichtungsmarkierungsfeld (14, 14', 14", 14‴) mindestens eine weitere Ebene (18, 18',18") mit den Ausrichtungsmarken (15, 15') aufweist, wobei die mindestens eine weitere Ebene (18, 18',18") zumindest parallel zu der ersten Ebene (18, 18',18") angeordnet ist.

13. Vorrichtung nach wenigstens einem der vorhergehenden Ansprüche, wobei die Vorrichtung mindestens ein weiteres Ausrichtungsmarkierungsfeld (14, 14', 14", 14‴) und mindestens eine weitere Erfassungseinheit (6) zum Erfassen des mindestens einen weiteren Ausrichtungsmarkierungsfeldes (14, 14', 14", 14‴) aufweist, wobei das mindestens eine weitere Ausrichtungsmarkierungsfeld (14, 14', 14", 14‴) ortsfest zu dem Substrathalter (9) angeordnet ist.

## Claims

1. A method for aligning a substrate with at least the following steps:
i) Provision of a substrate holder (9) with a substrate holder surface (20) designed to mount the substrate and an alignment marking field (14, 14', 14", 14"') fixed with respect to the substrate holder (9),
ii) alignment of the substrate, **characterised in that** the substrate is aligned with the aid of alignment marks (15, 15') of the alignment marking field (14, 14', 14", 14"') arranged one above the other, wherein the alignment of the substrate in step
ii) has the following steps, in particular with the following sequence:
a) detection of a first alignment mark (15, 15') of a first plane (18, 18', 18") of the alignment marking field (14, 14', 14", 14"') by a detection unit (6),
b) fixing of a focus position of the detection unit (6) after the detection in step a),
c) movement of the substrate holder (9) perpendicular to the first plane (18, 18', 18") of the alignment marking field (14, 14', 14", 14‴),
d) detection of a second alignment mark of a second plane (18, 18', 18") of the alignment marking field (14, 14', 14", 14"') by the detection unit (6),
wherein the first plane (18, 18', 18") and the second plane (18, 18', 18") are arranged parallel to one another, and wherein the first plane (18, 18', 18") and the second plane (18, 18', 18") are at a distance (17, 17', 17") from another.

2. The method according to claim 1, wherein in step a) additional alignment marks are detected on the substrate holder (9) or on the substrate by at least one additional detection unit (3).

3. The method according to at least one of the preceding claims, wherein during the movement of the substrate holder (9) in step iv), the detection unit (6) in the focus position continuously measures the alignment marking field (14, 14', 14", 14"').

4. The method according to at least one of the preceding claims, wherein after fixing the focus position in step b), the detection unit (6) is held fixed

5. The method according to at least one of the preceding claims, wherein when the first alignment mark (15, 15') is detected in step (a) and/or when the second alignment mark (15, 15') is detected in step d) by the detection unit (6), information on the location of the respective alignment mark (15, 15') within the alignment marking field (14, 14', 14", 14"') is also provided.

6. A device for aligning a substrate, at least comprising
A) a substrate holder (9) with a substrate holder surface (20) designed to mount the substrate, and
B) an alignment marking field (14, 14', 14", 14"') with alignment marks (15, 15') arranged fixed with respect to the substrate holder (9) and the substrate,
**characterised in that** the substrate can be aligned with the aid of alignment marks (15, 15') arranged upon one another, the device further comprising
C) a detection unit (9) for detecting the alignment marks (15, 15') of the alignment marking field (14, 14', 14", 14"') and
D) a movement device (10) for moving the substrate holder (9),
- wherein the alignment marks (15, 15') of the alignment marking field (14, 14', 14", 14‴) are arranged in a first plane (18, 18', 18") and a second plane (18, 18', 18"), and wherein the first plane (18, 18', 18") and the second plane (18, 18', 18") are arranged parallel to one another, and wherein the first plane (18, 18', 18") and the second plane (18, 18', 18") are at a distance (17, 1 7', 17") from each other, and
- wherein a first alignment mark (15, 15') of the alignment marks (15, 15') of the first plane (18, 18', 18") can be detected in a focus position of the detection unit (6), and wherein the focus position of the detection unit (6) can be fixed, and
- wherein in the focus position a second alignment mark (15, 15') of the alignment marks (15, 15') of the second plane can be detected by the detection unit (6),
and wherein the substrate holder (9) can be moved perpendicular to the first plane (15, 15') by the movement device (10).

7. The device according to at least one of the preceding claims, wherein the alignment marks (15, 15') of the first plane (18, 18', 18") and the alignment marks (15, 15') of the second plane (18, 18', 18") are arranged aligned above one another, in particular congruently, in the alignment marking field (14, 14', 14", 14"').

8. The device according to claim 6, wherein the alignment marks (15, 15') of the first plane (18, 18', 18") are arranged offset step-like with respect to the alignment marks (15, 15') of the second plane (18, 18', 18").

9. The device according to at least one of the preceding claims, wherein the alignment marking field (14, 14', 14", 14"') is arranged on a rear side of the substrate holder (9) facing away from the substrate holder surface (20).

10. The device according to claim 6, wherein a centre-point of the alignment marking field (14, 14', 14", 14‴) on the rear side of the substrate holder (9) is at least partially aligned with a centre-point of the substrate holder surface (20).

11. The device according to at least one of the preceding claims, wherein the alignment marking field (14, 14', 14", 14"') is arranged on the side of the substrate facing towards the substrate holder surface (20).

12. The device according to at least one of the preceding claims, wherein the alignment marking field (14, 14', 14", 14"') comprises at least one further plane (18, 18', 18") with the alignment marks (15, 15'), wherein the at least one further plane (18, 18', 18") is arranged at least parallel to the first plane (18, 18', 18").

13. The device according to at least one of the preceding claims, wherein the device comprises at least one further alignment marking field (14, 14', 14", 14‴) and at least one further detection unit (6) for detecting the at least one further alignment marking field (14, 14', 14", 14"'), wherein the at least one further alignment marking field (14, 14', 14", 14"') is arranged fixed with respect to the substrate holder (9).

## Revendications

1. Procédé d'alignement d'un substrat avec au moins les étapes suivantes :
i) prévision d'un support de substrat (9) avec une surface de support de substrat (20) conformée pour recevoir le substrat et un champ de marquage d'alignement (14, 14', 14", 14''') disposé fixement par rapport au support de substrat (9) ;
ii) alignement du substrat ;
**caractérisé en ce que** le substrat est aligné à l'aide de repères d'alignement superposés (15, 15') du champ de marquage d'alignement (14, 14', 14", 14'''),
l'alignement du substrat à l'étape ii) comportant les étapes suivantes, notamment avec le déroulement suivant :
a) détection d'une première marque d'alignement (15, 15') d'un premier plan (18, 18', 18") du champ de marquage d'alignement (14, 14' 14", 14''') par une unité de détection (6) ;
b) fixation d'une position focale de l'unité de détection (6) après la détection à l'étape a) ;
c) mouvement du support de substrat (9) perpendiculaire au premier plan (18, 18', 18"') du champ de marquage d'alignement (14, 14', 14", 14"') ;
d) détection par l'unité de détection (6) d'une seconde marque d'alignement d'un second niveau (18, 18', 18"') du champ de marquage d'alignement (14, 14' 14", 14"') ;
le premier plan (18, 18',18") et le second plan (18, 18', 18") étant disposés parallèlement l'un à l'autre, le premier plan (18, 18', 18‴) et le second plan (18, 18', 18") présentant une distance (17, 17', 17") l'un par rapport à l'autre.

2. Procédé selon la revendication 1, dans lequel, à l'étape a), des marques d'alignement supplémentaires sont enregistrées sur le support de substrat (9) ou sur le substrat d'au moins une unité de détection supplémentaire (3).

3. Procédé selon au moins l'une des revendications précédentes, dans lequel, pendant le mouvement du support de substrat (9) à l'étape IV), l'unité de détection (6), dans la position de détection, manque continuellement le champ de marquage d'alignement (14, 14', 14", 14‴).

4. Procédé selon au moins l'une des revendications précédentes, dans lequel, après la fixation de la position focale à l'étape b), l'unité de détection (6) est maintenue à emplacement fixe.

5. Procédure selon au moins une des revendications précédentes, dans lequel, lors de la détection de la première marque d'alignement (15, 15') à l'étape a) et/ou lors de la détection de la seconde marque d'alignement (15, 15') à l'étape d), l'unité de détection (6) fournit en outre des informations sur l'emplacement de la marque d'alignement correspondante (15, 15') dans le champ de marquage d'alignement (14, 14', 14", 14"').

6. Dispositif d'alignement d'un substrat, présentant au moins :
A) un support de substrat (9) avec une surface de support de substrat conformée pour recevoir le substrat (20) ; et
B) un champ de repérage d'alignement (14, 14', 14", 14") disposé fixement par rapport au support de substrat (9) avec des marques d'alignement (15, 15'), ;
**caractérisé en ce que** le substrat peut être aligné à l'aide de repères d'alignement superposés (15, 15'),
le dispositif comportant en outre :
C) une unité de détection (9) pour détecter les marques d'alignement (15, 15') du champ de marquage d'alignement (14, 14', 14", 14‴) ; et
D) un dispositif de mouvement (10) pour déplacer le support de substrat (9) ;
- les marques d'alignement (15, 15') du champ de repérage d'alignement (14, 14', 14", 14‴) étant disposées dans un premier plan (18, 18', 18") et un second plan (18, 18', 18"), le premier plan (18, 18', 18") et le second plan (18, 18', 18") étant disposés parallèlement l'un à l'autre ; et le premier plan (18, 18', 18") et le second plan (18, 18', 18") présentant une distance (17, 17', 17") l'un par rapport à l'autre, et
- une première marque d'alignement (15, 15') des marques d'alignement (15, 15') du premier plan (18, 18', 18") pouvant être détectée dans une position focale de l'unité de détection (6) et la position focale de l'unité de détection (6) pouvant être fixée ; et
- en position focale, l'unité de détection (6) pouvant détecter une seconde marque d'alignement (15, 15') des marques d'alignement (15, 15') du second plan (18, 18', 18") ;
et le support de substrat (9) pouvant être déplacé perpendiculairement au premier plan (15, 15') par le dispositif de mouvement (10).

7. Dispositif selon au moins une des revendications précédentes, les marques d'alignement (15, 15') du premier niveau (18, 18', 18") et les marques d'alignement (15, 15') du second niveau (18, 18', 18") étant disposées de manière à se superposer dans le champ de marquage d'alignement (14, 14', 14", 14‴), en particulier avec le même recouvrement.

8. Dispositif selon la revendication 6, les marques d'alignement (15, 15') du premier plan (18, 18', 18") étant disposées de manière à être décalées graduellement par rapport aux marques d'alignement (15, 15') du second plan (18, 18', 18").

9. Dispositif selon au moins l'une des revendications précédentes, le champ de marquage d'alignement (14, 14', 14", 14"') étant placé sur un arrière du support de substrat (9) détourné de la surface du support de substrat (20).

10. Dispositif selon la revendication 6, un point central du champ de marquage d'alignement (14, 14', 14", 14"') situé étant aligné au moins partiellement avec un point central de la surface du support de substrat (20) à l'arrière du support de substrat (9).

11. Dispositif selon au moins une des revendications précédentes, le champ de marquage d'alignement (14, 14', 14", 14''') étant placé sur un côté du substrat tourné vers la surface du support de substrat (20).

12. Dispositif selon au moins une des revendications précédentes, le champ de marquage d'alignement (14, 14', 14", 14''') présentant au moins un autre plan (18, 18', 18'') avec les marques d'alignement (15, 15'), l'au moins un autre plan (18, 18', 18") étant disposé au moins parallèlement au premier plan (18, 18', 18").

13. Dispositif selon au moins une des revendications précédentes, le dispositif présentant au moins un autre champ de marquage d'alignement (14, 14', 14", 14"') et au moins une autre unité de détection (6) permettant de détecter au moins un autre champ de marquage d'alignement (14, 14', 14", 14‴), l'au moins un autre champ de marquage d'alignement (14, 14', 14", 14"') étant disposé fixement par rapport au support de substrat (9).
